# EUROPEAN PATENT APPLICATION

(11) **EP 4 822 756 A1**
(43) Date of publication of application: **14.10.2026**
(21) Application number: 25745395.1
(22) Date of filing: 24.01.2025
(51) Int. Cl.: H01M 4/13, H01M 4/62, H01M 10/0585, H01M 10/052, H01M 10/42, C08G 61/12

(54) **ELECTRODE ASSEMBLY**

(30) Priority: 26.01.2024 KR 20240012285; 29.02.2024 KR 20240030196; 29.02.2024 KR 20240030199; 29.02.2024 KR 20240030201
(71) Applicant: LG Chem, Ltd., Seoul 07336 (KR); LG Energy Solution, Ltd., Seoul 07335 (KR)
(72) Inventor: SONG, In Taek, Daejeon 34122 (KR); KANG, Joon Koo, Daejeon 34122 (KR); KIM, Ki Hwan, Daejeon 34122 (KR); PARK, Eun Kyoung, Daejeon 34122 (KR); CHOI, Hyun Ju, Daejeon 34122 (KR); KOH, Jong Kwan, Daejeon 34122 (KR); YANG, Hee Myeong, Daejeon 34122 (KR); CHO, Woo Hyung, Daejeon 34122 (KR); LEE, Yu Mi, Daejeon 34122 (KR); LEE, Seok Kyeong, Daejeon 34122 (KR)
(74) Representative: Plasseraud IP
(86) International application number: PCT/KR2025/001485
(87) International publication number: WO 2025/159573

(57) **Abstract**

The present specification discloses an electrode assembly and a secondary battery. The present specification discloses an electrode assembly formed by combining: an electrode capable of exhibiting low resistance and excellent electrical characteristics in a normal state of a secondary battery, and securing stability by being rapidly converted into an insulator in an abnormal state thereof; and a separator which is referred to as a so-called SRS (safety-reinforcing separator). The present specification also discloses a secondary battery comprising the electrode assembly.

## Description

### Technical Field

This application claims the benefit of priority based on Korean Patent Application No. 10-2024-0012285 dated January 26, 2024, and Korean Patent Application Nos. 10-2024-0030201, 10-2024-0030199, and 10-2024-0030196 dated February 29, 2024, all the disclosures of which are incorporated herein by reference.

The present specification discloses an electrode assembly and a secondary battery comprising the same.

### Background Art

Secondary batteries (e.g., lithium-ion batteries) have various application fields, including portable electronics, electric vehicles (EVs), and renewable energy storage systems.

Secondary batteries applied as drive sources in transportation means such as electric vehicles require greater capacity and power.

The increased capacity and power of secondary batteries cause problems in stability of secondary batteries. For example, risk of a so-called thermal runaway phenomenon, or the like, which causes uncontrolled temperature increases and hazardous chemical leakage, increases with increased capacity and power.

Commercially available secondary batteries are provided with external safety devices (e.g., pressure-limited valves, cell-to-cell fire extinguishers, or high thermal insulating materials, etc.), but such safety devices do not effectively cope with dangerous situations such as the thermal runway, or exhibit a slow response speed.

### Disclosure

### Technical Problem

The present specification discloses an electrode assembly and a secondary battery. The present specification is intended to disclose an electrode assembly formed by combining: an electrode capable of exhibiting excellent electrical characteristics including low resistance in a normal state, and securing stability by being rapidly converted into an insulator in an abnormal state; and a separator which is referred to as a so-called SRS (safety-reinforcing separator).

The present specification also discloses a secondary battery comprising the electrode assembly.

### Technical Solution

The term room temperature means a natural temperature without artificial heating and cooling. The room temperature may be, for example, any temperature within a range of 10°C to 30°C, or a temperature of about 23°C, or about 25°C or so.

Among physical properties mentioned herein, the physical property affected by a measurement temperature is a physical property measured at room temperature, unless otherwise specified.

In this specification, the unit of temperature is Celsius (°C), unless otherwise specified.

The term normal pressure means a natural pressure without artificial pressurization and depressurization, which may typically mean a pressure within a range of about 730 mmHg to 790 mmHg or so.

Among physical properties mentioned herein, the physical property affected by a measurement pressure is a physical property measured at normal pressure, unless otherwise specified.

Among physical properties mentioned herein, the physical property affected by measurement humidity is a physical property measured at humidity without artificial adjustment under room temperature and normal pressure states, unless otherwise specified.

The term normal state means a normal operation or storage state of a secondary battery. For example, a normal charging, discharging, or storage state of a secondary battery is a normal state.

The term abnormal state means a dangerous state where abnormal temperature elevation, heat generation, or explosion, and the like has occurred or is likely to occur in secondary batteries, and the like.

The present specification discloses an electrode assembly.

The electrode assembly comprises a positive electrode (cathode); a negative electrode (anode); and a separator. The separator may be present between the positive electrode and the negative electrode. In the electrode assembly, the positive electrode, separator, and negative electrode may be laminated in this order to form a laminate.

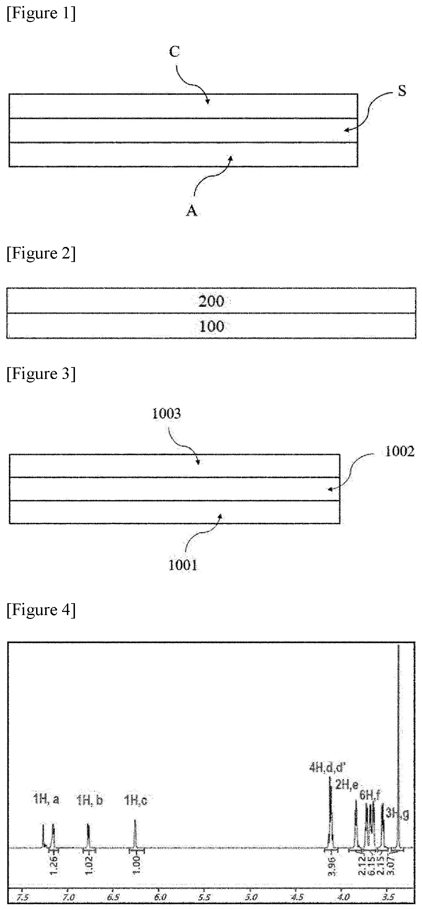

Figure 1 is an example of the laminate, which is a case where the positive electrode (C), separator (S), and negative electrode (A) are sequentially laminated.

The separator applied to the electrode assembly may be a separator called a so-called SRS (safety-reinforcing separator).

The SRS is a separator in the form that an inorganic particle layer is included on a surface of a separator base material (porous polymer membrane), which is a separator capable of exhibiting stability and maintaining performance even at higher temperatures relative to general separators. It is possible to significantly improve stability as such a separator is combined with an electrode having a polymer layer to be described below.

Such SRSs are well known.

For example, as shown in Figure 2, such an SRS may comprise a porous polymer membrane (100) and an inorganic particle layer (200). In the form of Figure 2, the inorganic particle layer (200) is formed on one surface of the polymer membrane (100), but the inorganic particle layer (200) may also be formed on both surfaces of the polymer membrane (100).

As the porous polymer membrane, a polymer membrane typically applied to the SRS may be used. For example, a material facilitating lithium-ion movement and having excellent wettability in an electrolyte may be used.

In one example, as the porous polymer membrane, a polyolefin-based polymer membrane may be used.

The polyolefin-based polymer membrane usable as the porous polymer membrane in the SRS is known in the industry, and for example, a porous polymer membrane may be applied thereto, which is produced from one or a combination of two or more selected from the group consisting of polyethylene, such as high-density polyethylene, low-density polyethylene, linear low-density polyethylene, and ultra-high molecular weight polyethylene; polypropylene; polybutylene; polypentene, polyhexene, polyoctene; and copolymers containing two or more monomer units selected from the group consisting of ethylene, propylene, butene, pentene, 4-methylpentene, hexene, and octene.

The porous polymer membrane typically has a thickness of about 1µm to 100µm, or 5µm to 50µm or so. In such a porous polymer membrane, pores with a size of about 0.001 µm to 50 µm or so are typically formed, and a porosity degree is typically adjusted within a range of 10% to 95%.

The SRS comprises an inorganic particle layer formed on one or both surfaces of the porous polymer membrane. The term inorganic particle layer is a layer containing inorganic particles.

As the inorganic particles, those that oxidation and reduction reactions do not occur within an operating voltage range (e.g., 0V to 5V based on Li/Li⁺) of electrochemical devices such as secondary batteries may be used, and inorganic particles with ion transfer capabilities may also be used. For example, if inorganic particles with a high permittivity are applied, they contribute to an increase in a dissociation degree of electrolyte salts, such as lithium salts, within the electrolyte, whereby it is possible to improve an ionic conductivity of the electrolyte.

For example, as the inorganic particles, inorganic particles with a permittivity constant of 5 or more and/or inorganic particles with lithium-ion transfer capabilities may be applied.

As an example of such inorganic particles, one or more types of inorganic particles selected from the group consisting of BaTiO₃, Pb(Zr,Ti)O₃(PZT), Pb₁₋ₓLaₓZr_{1-y}Ti_{y}O₃(PLZT), PB(Mg₃Nb_{2/3})O₃-PbTiO₃(PMN-PT), HfO₂, SrTiO₃, SnO₂, CeO₂, MgO, NiO, CaO, ZnO, ZrO₂, Y₂O₃, Al₂O₃, TiO₂ and SiC; and/or one or more types of inorganic particles selected from the group consisting of glass of (LiAlTiP)ₓO_{y} (0<x<4, 0<y<13) series such as Li₃PO₄, LiₓTi_{y}(PO₄)₃ (0<x<2, 0<y<3), LiₓAl_{y}Ti_{z}(PO₄)₃ (0<x<2, 0<y<1, 0<z<3) and/or 14Li₂O-9Al₂O₃-38TiO₂-39P₂O₅, LiₓLa_{y}TiO₃ (0<x<2, 0<y<3) and/or LiₓGe_{y}P_{z}S_{w} (0<x<4, 0<y<1, 0<z<1, 0<w<5) such as Li_{3.25}Ge_{0.25}P_{0.75}S₄ and/or glass (LiₓSi_{y}S_{z}, 0<x<3, 0<y<2, 0<z<4) of SiS₂ series such as Li₃PO₄-Li₂S-SiS₂ and/or glass (LiₓP_{y}S_{z}, 0<x<3, 0<y<3, 0<z<7) of P₂S₅ series such as LiI-Li₂S-P₂S₅, may be used.

Such inorganic particles typically have a size in a range of 0.001 µm to 10 µm. The size of such inorganic particles may be measured in the manner described in "15. Average particle diameter" of Example sections of the present specification.

In the SRS, the inorganic particle layer may comprise a polymer binder together with the inorganic particles. As such a polymer binder. typically, polyvinylidene fluoride-co-hexafluoropropylene, polyvinylidene fluoride-co-trichloroethylene, polymethylmethacrylate, polybutylacrylate, polyacrylonitrile, polyvinylpyrrolidone, polyvinylacetate, polyethylene-co-vinyl acetate, polyethylene oxide, cellulose acetate, cellulose acetate butyrate, cellulose acetate propionate, cyanoethylpullulan, cyanoethylpolyvinylalcohol, cyanoethylcellulose, cyanoethylsucrose, pullulan, carboxyl methyl cellulose, an acrylonitrile-styrene-butadiene copolymer, and/or polyimide, and the like may be used, and one, or a mixture of two or more of these binders may be used.

The content of the inorganic particles in the inorganic particle layer may be 10 weight% to 95 weight%, 30 weight% to 95 weight%, 50 weight% to 95 weight%, or 70 weight% to 90 weight%, and when the binder is included, it may be included in a ratio of about 5 to 100 parts by weight, or 10 to 50 parts by weight or so, relative to 100 parts by weight of the inorganic particles.

The inorganic particle layer may further comprise, in addition to the binder, known necessary components, for example, organic particles, and the like for enhancing bonding force with the binder polymer, and improving breathability, thermal contractility, and peel strength.

The inorganic particle layer may typically have a thickness of 0.1 µm to 50 µm, or 1 µm to 10 µm or so. Methods for producing the SRS are known, and the inorganic particle layer may be formed through such known methods.

The electrode assembly comprises a positive electrode and a negative electrode together with the separator.

The positive electrode and the negative electrode each comprise a current collector and an electrode active material layer formed on one or both surfaces of the current collector.

Either of or both the positive electrode and the negative electrode may comprise, for example, a polymer layer. Figure 3 is an example of an electrode structure comprising a polymer layer. When a polymer layer is included, the polymer layer (1002) may be present between the current collector (1001) and the active material layer (1003) of the positive electrode and/or the negative electrode.

For example, when the positive electrode comprises the polymer layer, the positive electrode may comprise a current collector; a polymer layer formed on the current collector; and an active material layer formed on the polymer layer.

In the electrode, the current collector and the polymer layer, and the polymer layer and the active material layer may be in contact with each other. In some cases, other elements may also exist between the current collector and the polymer layer, or between the polymer layer and the active material layer. While Figure 3 is a case where the active material layer (1003) exists only on one surface of the current collector (1001), the active material layer (1003) may also exist on both surfaces of the current collector (1001). In this case, the polymer layer (1002) may also exist in two layers between each of the active material layers (1003) present on both surfaces of the current collector (1001) and the current collector (1001), and may also exist in one layer between any one of the active material layers (1003) present on both surfaces and the current collector (1001).

The polymer layer exhibits a so-called PTC (positive temperature coefficient) effect. Therefore, the polymer layer may variably control charge transfer through the electrode depending on the temperature.

By applying such a polymer layer, the electrode can exhibit low resistance and excellent electrical properties under the normal state, and can ensure stability through resistance increase under the abnormal state.

In order that the polymer layer exhibits the effect, the oxidation potential of the polymer layer and the tendency of the PTC effect exhibited by the polymer layer must be controlled. The PTC effect is an effect that the resistance increases in proportion to the temperature. The temperature at the time when the resistance increases due to the PTC effect, and the resistance of the polymer layer before the resistance increase affect the performance of the secondary battery. If the PTC effect is excessively expressed in the normal state, the performance of the secondary battery cannot be properly expressed before stability is secured. In addition, if the oxidation potential of the polymer layer is not appropriately controlled in relation to the electrode active material, there is a problem that the performance of the battery, and the like in the normal state deteriorates.

The polymer layer disclosed herein has a PTC effect, and the oxidation potential of the polymer layer having this PTC effect and the PTC effect do not affect the performance of the secondary battery in the normal state, and are controlled so that stability can be secured in the abnormal state.

Through application of a conductive polymer having a long-chain hydrocarbon functional group and/or a polar functional group, it is possible to secure the effect. If necessary, a suitable PTC effect can also be secured by controlling a drying or annealing temperature during a polymer layer formation process. Furthermore, it is possible to adjust the oxidation potential of the polymer layer by combining such a conductive polymer with a conductive material.

The term polymer layer means a layer comprising a polymer. For example, the lower limit of the content of the polymer included in the polymer layer may be 30, 35, 40, 45, 50, 55, 60, 65, 70, 75, 80, 85, 90, or 95 or so, and the upper limit thereof may be 100, 95, 90, 85, 80, 75, 70, 65, 60, 55, or 50 or so. The content is a content of the polymer based on the total weight of the polymer layer, the unit of which is weight%. The content may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The polymer layer may not be a so-called electrode active material layer. Therefore, the content of the electrode active material within the polymer layer may be controlled. For example, the upper limit of the content of the electrode active material within the polymer layer may be 10, 9, 8, 7, 6, 5, 4, 3, 2, 1, 0.5, 0.1, 0.05, 0.01, 0.005, or 0.001 or so, and the lower limit thereof may be 0. The content is a content of the electrode active material based on the total weight of the polymer layer, the unit of which is weight%. The content may be within a range of less than or equal to, or less than any upper limit arbitrarily selected from the above-listed upper limits; or within a range of more than or equal to, or more than any lower limit arbitrarily selected from the above-listed lower limits while being less than or equal to, or less than any upper limit arbitrarily selected from the above-listed upper limits. Specific types of the electrode active material will be described below.

The polymer layer may comprise a conductive polymer. As is known, the conductive polymer is a polymer exhibiting conductivity by a conjugated system of a polymer chain and/or doping, and the like.

For example, the lower limit of the content of the conductive polymer included in the polymer layer may be 30, 35, 40, 45, 50, 55, 60, 65, 70, 75, 80, 85, 90, or 95 or so, and the upper limit thereof may be 100, 95, 90, 85, 80, 75, 70, 65, 60, 55, or 50 or so. The content is a content of the conductive polymer based on the total weight of the polymer layer, the unit of which is weight%. The content may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The oxidation potential characteristics of the polymer layer may be adjusted to suit the application. For example, the oxidation potential of the polymer layer needs to be maintained stably even when charging and discharging are repeatedly performed, or high-rate charging or discharging is performed, for the secondary battery to which the electrode is applied. The desired oxidation potential can be stably maintained even during repeated charging and discharging, and high-rate charging and discharging processes through use of a conductive polymer, introduction of a conductive material, and/or adjustment of heat treatment conditions, as described below, for the polymer layer.

For example, in the polymer layer, an absolute value of ΔV₁ in Equation 1 below may be within a predetermined range. [Equation 1] ${ΔV}_{1} = 100 \times \left({V}_{f}-{V}_{i}\right) / {V}_{i}$

In Equation 1, Vᵢ is an oxidation potential of the polymer layer after one cyclic voltage scan (cyclic voltammetry), and V_{f} is an oxidation potential of the polymer layer after ten cyclic voltage scans.

The oxidation potentials Vᵢ and V_{f} in Equation 1 are oxidation potentials measured for a coin cell to which the polymer layer is applied, and are the results measured in the manner described in "12. Measurement of oxidation potentials Vᵢ and V_{f}" of Example sections of this specification, which are Li/Li⁺ reference oxidation potentials.

The upper limit of the absolute value of ΔV₁ in Equation 1 may be 3%, 2.9%, 2.8%, 2.7%, 2.6%, 2.5%, 2.4%, 2.3%, 2.2%, 2.1%, 2.0%, 1.9%, 1.8%, 1.7%, 1.6%, 1.5%, 1.4%, 1.3%, 1.2%, 1.1%, 1.0%, 0.9%, 0.8%, 0.7%, 0.6%, 0.5%, or 0.4% or so, and the lower limit thereof may be 0%, 0.1%, 0.2%, 0.3%, 0.4%, 0.5%, or 1% or so. The ΔV₁ may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The oxidation potential Vᵢ of Equation 1 may be adjusted depending on the applied use of the polymer layer. The oxidation potential may be adjusted through adjustment of the type of the conductive polymer and/or the content of the conductive material.

The upper limit of the oxidation potential Vᵢ in Equation 1 may be 4.0 V, 3.95 V, 3.9 V, 3.85 V, 3.8 V, 3.75 V, 3.7 V, 3.65 V, 3.6 V, 3.55 V, or 3.5 V or so, and the lower limit thereof is not specifically limited, but may be, for example, 1 V, 1.5 V, 2 V, 2.5 V, 3 V, 3.1 V, 3.2 V, 3.3 V, or 3.4 V or so. The oxidation potential Vᵢ may be within a range of less than or equal to, or less than any upper limit arbitrarily selected from the above-listed upper limits; or within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

The polymer layer may have a lower oxidation potential than the active material layer (or electrode active material included in the active material layer). The active material layer or electrode active material is an active material layer or electrode active material of a positive or negative electrode comprising the polymer layer. The oxidation potential is an Li/Li⁺ reference oxidation potential, unless otherwise specified. The oxidation potential of the polymer layer is measured in the manner described in "4. Measurement of Polymer Layer Oxidation Potential" of Example sections of this specification, and the oxidation potential of the electrode active material and/or active material layer is measured in the manner described in "5. Measurement of Oxidation Potential of Electrode Active Material" of Example sections of this specification. The oxidation potential is an oxidation potential measured based on lithium and lithium ions (Li/Li⁺).

In one example, in the electrode assembly, the oxidation potential of the polymer layer may be controlled such that ΔV₂ in Equation 2 below falls within a predetermined range. [Equation 2] ${ΔV}_{2} = 100 \times \left({V}_{a}-{V}_{s}\right) / {V}_{a}$

In Equation 2, Vₐ is an oxidation potential of the active material layer or the electrode active material contained therein, and Vₛ is an oxidation potential of the polymer layer.

The lower limit of ΔV₂ in Equation 2 may be 0%, 0.5%, 1%, 1.5%, 2%, 2.5%, 3%, 3.5%, 4%, 4.5%, 5%, 5.5%, 6%, 6.5%, 7%, 7.5%, 8%, or 8.5% or so, and the upper limit thereof may be 0%, 20%, 19%, 18%, 17%, 16%, 15%, 14%, 13%, 12%, 11%, 10%, 9%, 8%, 7%, 6%, 5%, or 4.5% or so. ΔV₂ in Equation 2 may be within a range of more than or equal to, or more than any one lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits. By controlling the oxidation potential of the polymer layer to satisfy the above relationship, it is possible to provide a battery operating stably and efficiently in the normal state.

The oxidation potential Vₛ of the polymer layer is not particularly limited if it satisfies the above relationship. The lower limit of the oxidation potential Vₛ of the polymer layer may be 2 V, 2.1 V, 2.2 V, 2.3 V, 2.4 V, 2.5 V, 2.6 V, 2.7 V, 2.8 V, 2.9 V, 3 V, 3.1 V, 3.2 V, 3.3 V, 3.4 V, 3.5 V, 3.6 V, or 3.7 V or so, and the upper limit thereof may be 6 V, 5.5 V, 5 V, 4.9 V, 4.8 V, 4.7 V, 4.6 V, 4.5 V, 4.4 V, 4.3 V, 4.2 V, 4.1 V, 4.0 V, 3.9 V, 3.8 V, 3.7 V, 3.6 V, or 3.5 V or so. The oxidation potential may be within a range of less than or equal to, or less than any upper limit arbitrarily selected from the above-listed upper limits; within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

In one example, the polymer layer or the electrode to which the polymer layer is applied may have a DC resistance in a certain level or less. Accordingly, stable operation or storage of the secondary battery in a normal state may be possible. The upper limit of the DC resistance may be 10,000, 9500, 9000, 8500, 8000, 7500, 7000, 6500, 6000, 5500, 5000, 4500, 4000, 3500, 3000, 2500, 2000, 1500, 1000, 950, 900, 850, 800, 750, 700, 650, 600, 550, 500, 450, 400, 350, 300, 250, 200, 150, 100, 90, 80, 70, or 60 or so, and the lower limit thereof may also be 5, 10, 50, 100, 150, 200, 250, 300, 350, 400, 450, 500, 550, or 600 or so. The unit of the DC resistance is Ω·cm. The DC resistance may be within a range of less than or equal to, or less than any upper limit arbitrarily selected from the above-listed upper limits; or within a range of more than or equal to, or more than any lower limit arbitrarily selected from the above-listed lower limits while being less than or equal to, or less than any upper limit arbitrarily selected from the above-listed upper limits. The DC resistance is measured in the manner described in "6. DC resistance measurement method" of Example sections of this specification.

In one example, the polymer layer or the polymer layer electrode may have an AC impedance resistance at 25°C in a certain level or less. Accordingly, stable operation or storage of the secondary battery may be possible in a normal state. The upper limit of the AC impedance resistance may be 1,000, 950, 900, 850, 800, 750, 700, 650, 600, 550, 500, 450, 400, 350, 300, 250, 200, 150, 100, 95, 90, 85, 80, 75, 70, 65, 60, 55, 50, 45, 40, 35, 30, 25, 20, 15, 10, 9, 8, or 7 or so, and the lower limit thereof may also be 1, 2, 3, 4, 5, 6, 7, 8, 9, or 10 or so. The unit of the AC impedance resistance is Ω. The AC impedance resistance may be within a range of less than or equal to, or less than any upper limit arbitrarily selected from the above-listed upper limits; or within a range of more than or equal to, or more than any lower limit arbitrarily selected from the above-listed lower limits while being less than or equal to, or less than any upper limit arbitrarily selected from the above-listed upper limits. The AC resistance is measured in the manner described in "7. AC impedance resistance" of Example sections of this specification.

By exhibiting the DC resistance and/or AC impedance resistance, the secondary battery to which the electrode is applied can be stably operated and stored in a normal state.

The electrode exhibits increased resistance in an abnormal state, and by blocking energization of the electrode assembly therethrough, it is possible to ensure stability.

The polymer layer, or the electrode or electrode assembly to which the polymer layer is applied may exhibit characteristics in which ΔR1 in Equation 3 below is in a certain level or more. [Equation 3] $ΔR 1 = Max \left\{\left({R}_{n + 5}/{R}_{n}\right)/5\right\}$

In Equation 3, Rₙ is the DC resistance at an arbitrary temperature n°C within a range of 25°C to 135°C, Rₙ₊₅ is the DC resistance at a temperature ((n+5)°C) that is 5°C higher than the temperature n°C, and Max{(Rₙ₊₅/Rₙ)/5} is the maximum value among the (Rₙ₊₅/Rₙ)/5 values confirmed within the temperature range of 25°C to 135°C.

The method of measuring ΔR1 of Equation 3 is described in the "8. Measurement of maximum resistance change rate (DC resistance)" section of Examples sections. In the method of confirming ΔR1 above, the initial temperature is 25°C and the final temperature is 135°C. The Rₙ₊₅ and Rₙ are confirmed by measuring the DC resistance at each temperature while increasing the temperature by 5°C from the initial temperature of 25°C. For example, when n is 90, R₉₅/R₉₀ is the ratio of the DC resistance at 95°C to the DC resistance at 90°C. The matter that ΔR1 exhibits a certain level or more at any temperature within the temperature range of 25°C to 135°C means that the resistance increases relatively rapidly at any temperature within the temperature range.

The lower limit of ΔR1 in Equation 3 may be 10, 50, 100, 110, 120, 130, 140, 150, 160, 170, 180, or 190, and the upper limit thereof may also be 1,000, 950, 900, 850, 800, 750, 700, 650, 600, 550, 500, 450, 400, 350, 300, 250, 200, 190, or 180 or so. The unit of the ΔR1 is Ω·cm/°C. The ΔR1 may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

The temperature (on-set temperature) at which ΔR1 of the above range is confirmed may be within a predetermined range. The temperature range is very important in terms of ensuring stable operation and stability of the secondary battery. That is, if the temperature is the temperature range in the normal state of the secondary battery, the temperature increase at the relevant temperature adversely affects the performance of the secondary battery. The lower limit of the on-set temperature may be 70°C, 75°C, 80°C, 81°C, 82°C, 83°C, 84°C, 85°C, 86°C, 87°C, 88°C, 89°C, 90°C, 91°C, 92°C, 93°C, 94°C, or 95°C or so, and the upper limit thereof may be 200°C, 190°C, 180°C, 170°C, 160°C, 150°C, 140°C, 130°C, 120°C, 110°C, 100°C, or 90°C or so. The temperature may be within a range of more than, or equal to or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

By controlling the resistance increase to occur in the temperature range, stable operation and storage in a normal state and stable blocking of energization in an abnormal state can be achieved. For example, through adjustment of the temperature range, stable storage is possible even when the secondary battery is stored at a relatively high temperature.

The polymer layer, and the electrode, to which the polymer layer is applied, can exhibit a characteristic in which ΔR2 of Equation 4 below is in a certain level or more. [Equation 4] $ΔR 2 = Max \left\{\left({R}_{z + 5}/{R}_{z}\right)/5\right\}$

In Equation 4, R_{z} is the AC impedance resistance at an arbitrary temperature n°C within the range of 25°C to 135°C, R_{z+5} is the AC impedance resistance at a temperature ((n+5)°C) that is 5°C higher than the temperature n°C, and Max{(R_{z+5}/R_{z})/5} is the maximum value among the (R_{z+5}/R_{z})/5 values confirmed within the temperature range of 25°C to 135°C.

The method of measuring ΔR2 of Equation 4 above is described in the "9. Measurement of maximum resistance change rate (AC impedance)" section of Example sections. In the method for confirming ΔR2 above, the initial temperature is 25°C and the final temperature is 135°C. The AC impedance resistance is measured at each temperature while increasing the temperature by 5°C from the initial temperature of 25°C, thereby confirming the R_{z+5} and R_{z}. For example, when z is 90, R₉₅/R₉₀ is the ratio of the AC impedance resistance at 95°C to the AC impedance resistance at 90°C.

The lower limit of ΔR2 in Equation 4 above may be 5, 10, 12, 14, 16, 18, 20, 22, 24, 26, 28, 30, or 33 or so, and the upper limit thereof may be 100, 95, 90, 85, 80, 75, 70, 65, 60, 55, 50, 45, 40, 35, 30, 25, or 20 or so. The unit of ΔR2 above is Ω/°C, and the range may be within a range of more than, or equal to or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

By securing the characteristics, it is possible to show an increase in resistance in an abnormal state, and by blocking energization therethrough, it is possible to ensure stability.

The temperature (on-set temperature) at which ΔR2 above is confirmed may be within a predetermined range. The lower limit of the temperature may be 70°C, 75°C, 80°C, 81°C, 82°C, 83°C, 84°C, 85°C, 86°C, 87°C, 88°C, 89°C, 90°C, 91°C, 92°C, 93°C, 94°C, or 95°C or so, and the upper limit thereof may be 200°C, 190°C, 180°C, 170°C, 160°C, 150°C, 140°C, 130°C, 120°C, 110°C, 100°C, or 90°C or so. The temperature may be within a range of more than, or equal to or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

By controlling the resistance increase to occur in the temperature range, stable operation and storage in a normal state and stable blocking of energization in an abnormal state can be possible. For example, through adjustment of the temperature range, stable storage is possible even when the secondary battery is stored at a relatively high temperature.

The polymer layer, the electrode to which the polymer layer is applied, or the secondary battery applied by the same can exhibit characteristics in which the absolute value of ΔR3 in Equation 5 below is within a certain range. [Equation 5] $ΔR 3 = 100 \times \left(C1-C2\right) / C 1$

In Equation 5, C1 is a discharge capacity at room temperature (about 25°C), and C2 is a discharge capacity after storage at 70°C for 60 hours. C1 and C2 of Equation 5 are discharge capacities of the polymer layer measured for a coin cell.

The upper limit of the absolute value of ΔR3 in Equation 5 may be 10%, 9.5%, 9%, 8.5%, 8%, 7.5%, 7%, 6.5%, 6%, 5.5%, 5%, 4.5%, 4%, 3.5%, 3%, 2.5%, 2%, 1.5%, 1%, or 0.5% or so, and the lower limit thereof may be 0%, 0.5%, or 1.5% or so. The absolute value of ΔR3 may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. ΔR3 of the above range means that stable operation and storage are possible even when the secondary battery is operated and stored at a relatively high temperature within the range of the normal state.

The polymer layer, the electrode to which the polymer layer is applied, or the secondary battery applied by the same may exhibit a characteristic in which the absolute value of ΔR4 in Equation 6 is within a predetermined range. [Equation 6] $ΔR 4 = 100 \times \left({C}_{25}-{C}_{130}\right) / {C}_{25}$

In Equation 6, C₂₅ is a discharge capacity at room temperature (about 25°C), and C₁₃₀ is a discharge capacity after storage at 130°C for 10 minutes.

C₂₅ and C₁₃₀ of Equation 5 are discharge capacities measured for a coin cell to which the polymer layer is applied, and a specific method of measuring the same is summarized in "11. High-temperature discharge capacity reduction rate" of Example sections.

The lower limit of the absolute value of ΔR4 in Equation 6 may be 50%, 52%, 54%, 56%, 58%, 60%, 62%, 64%, 66%, 68%, 70%, 72%, 74%, 76%, 78%, 80%, 82%, 84%, 86%, or 88% or so, and the upper limit thereof may also be 200%, 180%, 160%, 140%, 120%, 100%, 95%, 90%, 85%, or 80% or so. The absolute value of ΔR4 may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits. ΔR4 in the above range means that stability is effectively secured by an increase in resistance in an abnormal state of the secondary battery.

The polymer layer may exhibit excellent electrical reactivity. For example, the polymer layer may be formed such that Q in Equation 7 below falls within a predetermined range. [Equation 7] $Q = {R}_{3 V} / {R}_{3.5 V}$

In Equation 7, R_{3V} is the AC impedance resistance under external voltage conditions of 25°C and 3V, and R_{3.5V} is the AC impedance resistance at the time point when 1 second has passed after the external voltage has been converted to 3.5V from the external voltage conditions of 25°C and 3V. The AC impedance resistances R_{3V} and R_{3.5V} are resistances confirmed in a coin cell to which the electrode assembly is applied, and the measurement method thereof follows the manner described in "13. AC impedance resistance measurement at 3V and 3.5V" section of Example sections of this specification.

The lower limit of the Q value may be 5, 6, 7, 8, 9, 10, 20, 30, 40, 50, 60, 70, 80, 85, 86, 87, 88, 89, 90, 91, 92, 93, 94, 95, 96, 97, 98, 99, 100, 101, 102, 103, 104, 105, 106, 107, 108, 109, 110, 115, 120, 125, 130, 135, or 140 or so, and the upper limit thereof may be 400, 350, 300, 250, 200, 195, 190, 185, 180, 175, 170, 165, 160, 155, 150, 145, 140, 130, 120, 110, 100, 99, 98, 97, 96, 95, 94, 93, 92, 91, 90, 89, 88, 85, 80, 70, 60, 50, 30, 20, or 10 or so. The Q value may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

The fact that the Q value of Equation 7 above is in a certain value or more means that if the external voltage condition changes from 3V to 3.5V, a rapid resistance decrease occurs within a short period of time, which indicates excellent electrical reactivity of the polymer layer or the conductive polymer included therein.

The AC impedance resistance R_{3.5V} in Equation 7 may be within a certain range. For example, the upper limit of the AC impedance resistance R_{3.5V} may be 5000, 4500, 4000, 3500, 3000, 2500, 2000, 1500, 1000, 900, 800, 700, 600, 500, 400, 350, 300, or 250 or so, and the lower limit thereof may be 10, 15, 20, 25, 30, 35, 40, 45, 50, 55, 60, 65, 70, 75, 80, 85, 90, 95, 100, 150, 200, 250, 300, 500, 1000, 1500, 2000, 2500, 3000, 3500, 4000, 4500, or 5000 or so. The unit of the AC impedance resistance R_{3.5V} is Ω, and the range may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The polymer layer exhibits a precisely designed PTC (Positive Temperature Coefficient) effect, and accordingly, when the polymer layer is applied to an electrode, the electrode may maintain excellent electrical properties at temperatures in a normal state, and then may exhibit a resistance-increasing effect in an abnormal state.

For example, the polymer layer may be designed such that P in Equation 8 below falls within a predetermined range. [Equation 8] $P = {R}_{130} / {R}_{25}$

In Equation 8, R₁₃₀ is the AC impedance resistance at 130°C, and R₂₅ is the AC impedance resistance at 25°C. The AC impedance resistances R₁₃₀ and R₂₅ are resistances confirmed in a coin cell to which the electrode assembly is applied, and the measurement method thereof follows the manner described in "14. AC impedance resistance measurement at room temperature (25°C) and 130°C" section of Example sections of this specification.

The lower limit of P in Equation 3 may be 60, 70, 80, 90 100, 150, 200, 250, 300, 350, 400, 450, 500, 550, 600, 650, 700, 750, 800, 850, 900, 950, 1,000, 1,100, 1,200, 1,300, 1,400 or 1,450 or so, and the upper limit thereof is not particularly limited, but may be 10,000, 9,000, 8,000, 7,000, 6,000, 5,000, 4,000, 3,000, 2,000 1,500, 1,400, 1,300, 1,200, 1,100, 1,000, 950, 900, or 850 or so. The P may be within a range of more than or equal to, or more than any lower limit arbitrarily selected from the above-listed lower limits; or within a range of less than, or equal to or less than any upper limit arbitrarily selected from the above-listed upper limits while being more than or equal to, or more than any lower limit arbitrarily selected from the above-listed lower limits.

The polymer layer exhibits a large resistance difference between room temperature (about 25°C) and a high temperature (130°C), which is due to the PTC effect.

The polymer layer, the current collector comprising the same, or the electrode comprising the same may exhibit a low resistance at room temperature (about 25°C) while exhibiting the P value.

For example, the upper limit of the resistance R₂₅ of the AC impedance of Equation 3 above may be 500, 450, 400, 350, 300, 250, 200, 150, 100, 90, 80, 70, 60, 50, 45, 40, 35, 30, 28, 26, 24, or 22 or so, and the lower limit thereof may be, for example, 10, 15, 20, 25, 30, 35, or 40 or so. The unit of the resistance R₂₅ of the AC impedance is Ω, and the range may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The electrode assembly comprising the polymer layer and the separator can exhibit excellent stability even against external impacts.

For example, the electrode assembly can exhibit a maximum temperature in a certain level or less during an impact test.

The maximum temperature is the maximum temperature confirmed during an impact test performed according to Test Example 3 section of this specification. The upper limit of this maximum temperature may be 200°C, 150°C, or 100°C or so, and the lower limit thereof may be 20°C, 40°C, 60°C, or 80°C or so. The maximum temperature may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

Furthermore, the electrode assembly can exhibit a temperature rise rate in a certain level or less during the impact test. The upper limit of the temperature rise rate may be 40, 35, 30, 25, 20, 15, 10, 5, 1, or 0.5 or so, and the lower limit thereof may be 0.01, 0.05, 0.1, 0.15, or 0.2 or so. The temperature rise rate may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. The unit of the temperature rise rate is 40°C/sec.

The maximum temperature and temperature rise rate may be confirmed according to the contents of Test Example 3 of this specification.

The conductive polymer included in the polymer layer may have a weight average molecular weight within a predetermined range. The lower limit of the weight average molecular weight of the conductive polymer may be 10,000, 15,000, 20,000, 25,000, 30,000, 35,000, 40,000, 45,000, 50,000, 55,000, 60,000, 65,000, 70,000, 75,000, 80,000, 85,000, 90,000, 95,000, 100,000, 105,000, 110,000, 115,000, 120,000, 125,000, 130,000, 135,000, 140,000, 145,000, or 150,000 or so, and its upper limit thereof may also be 1,000,000, 950,000, 900,000, 850,000, 800,000, 750,000, 700,000, 650,000, 600,000, 550,000, 500,000, 450,000, 400,000, 350,000, 300,000, 250,000, 200,000, 150,000, or 120,000 or so. The weight average molecular weight may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. The unit of the weight average molecular weight is g/mol.

The molecular weight distribution, i.e., the ratio of the weight average molecular weight (Mw) to the number average molecular weight (Mn), of the conductive polymer may be within a predetermined range. The lower limit of the molecular weight distribution may be 1, 1.5, 2, 2.5, 3, 3.5, 4, or 4.5 or so, and the upper limit thereof may be 8, 7.5, 7, 6.5, 6, 5.5, 5, 4.5, 4, or 3.5 or so. The molecular weight distribution may be within a range of more than or equal to, or more than any lower limit arbitrarily selected from the above-listed lower limits; or within a range of less than or equal to, or less than an arbitrarily selected upper limit from the above-listed upper limits; or within a range of less than or equal to, or less than any upper limit arbitrarily selected from the above-listed upper limits while being more than or equal to, or more than an arbitrarily selected lower limit from the above-listed lower limits.

The weight-average molecular weight and molecular weight distribution may be evaluated in the manner described in "2. GPC (Gel Permeation Chromatograph)" of Example sections of this specification.

The conductive polymer may be polythiophene.

The term polythiophene means a polymer containing thiophene units in a certain level or more.

The term thiophene unit means a monomer unit in which the monomer is a thiophene monomer.

The term thiophene monomer is a monomer of a thiophene series, which means a monomer containing a thiophene skeleton.

The term monomer unit means a form in which any monomer is polymerized to be included in a polymer.

For example, the lower limit of the ratio of the mole number of the thiophene unit in the polythiophene may be 50 mol%, 55 mol%, 60 mol%, 65 mol%, 70 mol%, 75 mol%, 80 mol%, 85 mol%, or 90 mol% or so, relative to the mole number of all monomer units of the polythiophene, and the upper limit thereof may be 100 mol%, 95 mol%, 90 mol%, 85 mol%, 80 mol%, 75 mol%, 70 mol%, 65 mol%, or 60 mol% or so, relative to the mole number of all monomer units of the polythiophene. The ratio of the thiophene unit may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

The conductive polymer may contain a long-chain hydrocarbon functional group or a monomer unit having the long-chain hydrocarbon functional group (hereinafter, may be referred to as unit A). The monomer having the long-chain hydrocarbon functional group may be a thiophene monomer.

The term long-chain hydrocarbon functional group means a monovalent hydrocarbon group having a carbon number in a certain level or more, or a monovalent functional group including the monovalent hydrocarbon group having a carbon number in a certain level or more.

For example, the lower limit of the carbon number (i.e., the carbon number of the monovalent hydrocarbon group) present in the long-chain hydrocarbon functional group may be 3, 4, 5, 6, 7, 8, 9, 10, 11, or 12 or so, and the upper limit thereof may be 30, 29, 28, 27, 26, 25, 24, 23, 22, 21, 20, 19, 18, 17, 16, 15, 14, 13, 12, 11, 10, 9, 8, 7, 6, 5, or 4 or so. The carbon number may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The carbon number may be the total carbon number present in the long-chain hydrocarbon functional group, or the carbon number of the hydrocarbon chain of the linear structure included in the functional group. That is, the monovalent hydrocarbon group present in the long-chain hydrocarbon functional group may have a linear structure or a branched structure, and even in the case of the branched structure, the carbon number constituting the longest linear chain in the relevant branched structure may be within the range. For example, if the branched structure is a 2-ethylhexyl group, the carbon number constituting the longest linear chain is 6.

An example of the long-chain hydrocarbon functional group may be exemplified by one or more selected from the group consisting of an alkyl group, an alkenyl group, an alkynyl group, an alkoxy group, an alkylcarbonyl group, and an alkylcarbonyloxy group. In an appropriate example, the long-chain hydrocarbon functional group may be an alkyl group and/or an alkoxy group.

The carbon number present in the alkyl group, the alkenyl group, the alkynyl group, the alkoxy group, the alkyl group of the alkylcarbonyl group, and the alkyl group of the alkylcarbonyloxy group may be in the range of the carbon number (i.e., the carbon number of the monovalent hydrocarbon group) present in the long-chain hydrocarbon functional group.

For example, the alkyl group, the alkenyl group, the alkynyl group, the alkoxy group, the alkyl group of the alkylcarbonyl group, and the alkyl group of the alkylcarbonyloxy group may be a linear or branched structure. In the case of a branched chain, the carbon number constituting the longest linear chain in the relevant branched structure may be in the range.

The alkyl group, the alkenyl group, the alkynyl group, the alkoxy group, the alkylcarbonyl group, or the alkylcarbonyloxy group, which is the long-chain hydrocarbon functional group, may also be optionally substituted with one or more substituents.

Such a long-chain hydrocarbon functional group is a functional group capable of imparting appropriate mobility to the monomers or the conductive polymer itself during the polymerization process of the conductive polymer. A monomer containing such a long-chain hydrocarbon functional group imparts appropriate mobility to a monomer mixture, and diffuses within the monomer mixture as well, thereby enabling polymerization to occur with an excellent efficiency. Furthermore, the conductive polymer having the long-chain hydrocarbon functional group can allow a polymer layer to be formable stably and uniformly through the appropriate mobility between the current collector and the active material layer.

The long-chain hydrocarbon functional group is appropriately oriented during a drying or annealing process applied in a formation process of the polymer layer, thereby also enabling the PTC effect suitable to the polymer to be adjustable. If a certain amount of heat energy is applied to the long-chain hydrocarbon functional group, it vibrates due to the heat, and de-doping of anions bound to the polymer is promoted by this vibration (thermal vibration), and accordingly, a resistance increase is induced. The temperature at which the thermal vibration occurs may be controlled by the length and/or amount of the long-chain hydrocarbon functional group. For example, under the same temperature, the thermal vibration of a relatively long chain is greater than that of a relatively short chain, whereby the long chain can induce a resistance-enhancing effect at a relatively low temperature. Therefore, the desired PTC effect can be set by controlling the length and/or ratio of the long-chain hydrocarbon functional group.

For example, to appropriately implement the effect, the molar ratio of the monomer unit (unit A) bearing the long-chain hydrocarbon functional group relative to the mole number of all monomer units in the conductive polymer may be adjusted. For example, the lower limit of the molar ratio may be 50 mol%, 55 mol%, 60 mol%, 65 mol%, 70 mol%, 75 mol%, 80 mol%, 85 mol%, 90 mol%, or 95 mol% or so, and the upper limit thereof may be 99 mol%, 98 mol%, 96 mol%, 95 mol%, or 90 mol% or so. The ratio may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The conductive polymer may contain, as the long-chain hydrocarbon functional group, a hydrocarbon functional group having 10 or more carbon atoms (hereinafter, may be referred to as a first hydrocarbon functional group) and a hydrocarbon functional group having 9 or less carbon atoms (hereinafter, may be referred to as a second hydrocarbon functional group).

The lower limit of the carbon number of the first hydrocarbon functional group may be 10, 11, or 12 or so, and the upper limit thereof may be 20, 19, 18, 17, 16, 15, 14, 13, 12, 11, or 10 or so. The carbon number of the first hydrocarbon functional group may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The lower limit of the carbon number of the second hydrocarbon functional group may be 3, 4, 5, 6, 7, or 8 or so, and the upper limit thereof may be 9, 8, 7, or 6 or so. The carbon number of the second hydrocarbon functional group may be within a range of less than or equal to, or less than any upper limit arbitrarily selected from the above-listed upper limits; or within a range of more than or equal to, or more than any lower limit arbitrarily selected from the above-listed lower limits while being less than or equal to, or less than any upper limit arbitrarily selected from the above-listed upper limits.

The carbon number of each of the first and second hydrocarbon functional groups may be the carbon number of the straight-structure hydrocarbon chain present in the hydrocarbon functional group. For example, the first and second hydrocarbon functional groups may each independently be at least one selected from the group consisting of an alkyl group, an alkenyl group, an alkynyl group, an alkoxy group, an alkylcarbonyl group, and an alkylcarbonyloxy group, and may be, in an appropriate example, an alkyl group and/or an alkoxy group, where the carbon number may be the carbon number of the alkyl group, the alkenyl group, the alkynyl group, the alkoxy group, the alkyl group of the alkylcarbonyl group, and the alkyl group of the alkylcarbonyloxy group.

The alkyl group, the alkenyl group, the alkynyl group, the alkoxy group, the alkyl group of the alkylcarbonyl group, and the alkyl group of the alkylcarbonyloxy group may have a linear or branched structure, where in the case of the linear chain, the total carbon number may be within the above range, and in the case of the branched chain, the carbon number constituting the longest linear chain in the relevant branched structure may be within the above range.

The carbon number of the long-chain hydrocarbon functional group is related to the vibration characteristics due to applied thermal energy, and if the carbon number changes, such vibration characteristics also change, and the vibration characteristics are also linked to the PTC characteristics of the conductive polymer. In the conductive polymer, the first hydrocarbon functional group primarily plays a role in adjusting the temperature where the PTC effect is expressed, i.e., the temperature where the resistance increase occurs, and the second hydrocarbon functional group plays a role in suppressing the resistance increase at relatively low temperatures.

In the conductive polymer, the ratio of the total mole number of the monomer units having the first hydrocarbon functional group and the monomer units having the second hydrocarbon functional group relative to the mole number of all monomer units of the conductive polymer may be adjusted within the range of the ratio of unit A as described above.

The lower limit of the ratio (M2/M1) of the mole number (M2) of the second hydrocarbon functional group or the monomer unit having the functional group to the mole number (M1) of the first hydrocarbon functional group or the monomer unit having the functional group in the conductive polymer may be 0.01, 0.05, 0.1, 0.5, 1, 1.5, or 2 or so, and the upper limit thereof may be 100, 95, 90, 85, 80, 75, 70, 65, 60, 55, 50, 45, 40, 35, 30, 25, 20, 15, 10, 9, 8, 7, 6, 5, 4, 3, 2, 1, or 0.7 or so. The ratio may be less than or equal to, or less than any upper limit arbitrarily selected from the above-listed upper limits, or may be more than or equal to, or more than any lower limit arbitrarily selected from the above-listed lower limits, or may also have a range of more than or equal to, or more than any lower limit arbitrarily selected from the above-listed lower limits while being less than or equal to, or less than any upper limit arbitrarily selected from the above-listed upper limits.

Under such a ratio, the conductive polymer or polymer layer can exhibit an appropriate PTC (Positive Temperature Coefficient) effect, and exhibit stable electrical properties at temperatures in a normal state, and as surface properties of the polymer layer are adjusted, it can allow excellent adhesive force to be ensured in the electrode or electrode current collector.

The conductive polymer may contain a polar functional group or a monomer unit (hereinafter, may be referred to as unit B) having the polar functional group, together with the long-chain hydrocarbon functional group or unit A. The monomer having the polar functional group may be a thiophene monomer.

The term polar functional group is a functional group containing one, or two or more polar atoms, for example, oxygen and/or nitrogen. An example of such a functional group includes a carboxyl group, a hydroxy group, an amino group, a cyano group, a nitro group, an ether group, or a functional group of Formula 1 below, but is not limited thereto. In one example, as the polar functional group, a functional group of Formula 1 below may be applied.

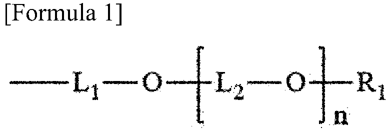

In Formula 1, L₁ is a single bond, an alkylene group or an alkylidene group, L₂ is an alkylene group or an alkylidene group, R₁ is hydrogen or an alkyl group, and n is an arbitrary number.

In Formula 1, the matter that L₁ is a single bond means a form that L₁ does not exist and the oxygen atom between L₁ and L₂ is directly connected to the monomer.

In one example, the alkyl group of R₁ in Formula 1 may be an alkyl group with 1 to 20 carbon atoms, 1 to 16 carbon atoms, 1 to 12 carbon atoms, 1 to 8 carbon atoms or 1 to 4 carbon atoms, or may be a methyl group or an ethyl group. The alkyl group may be linear, branched, or cyclic, and may be linear or branched, as appropriate. The alkyl group may be optionally substituted with one or more substituents.

The term alkylene group means a divalent functional group formed by removing one hydrogen atom from each of two different carbon atoms in an alkane, and the term alkylidene group means a divalent functional group formed by removing two hydrogen atoms from one carbon atom in an alkane.

In one example, the alkylene groups of L₁ and L₂ in Formula 1 may each be an alkylene group with 2 to 20 carbon atoms, 2 to 16 carbon atoms, 2 to 12 carbon atoms, 2 to 8 carbon atoms or 2 to 4 carbon atoms, or may each be an ethylene group or a propylene group. The alkylene group may be linear, branched, or cyclic, and may be linear or branched, as appropriate. The alkylene group may be optionally substituted with one or more substituents.

In one example, the alkylidene groups of L₁ and L₂ in Formula 1 may each be an alkylidene group with 1 to 20 carbon atoms, 1 to 16 carbon atoms, 1 to 12 carbon atoms, 1 to 8 carbon atoms or 1 to 4 carbon atoms, or may each be a methylidene group, an ethylidene group or a propylidene group. The alkylidene group may be linear, branched, or cyclic, and may be linear or branched, as appropriate. The alkylidene group may be optionally substituted with one or more substituents.

In Formula 1, the lower limit of n may be 1, 2, 3, or 4, and the upper limit thereof may be 10, 9, 8, 7, 6, 5, 4, or 3 or so. The above n may be within a range of more than or equal to, or more than any lower limit arbitrarily selected from the above-listed lower limits while being less than or equal to, or less than any upper limit arbitrarily selected from the above-listed upper limits.

Through application of the polar functional group, the polymer layer can be bonded to another layer to have appropriate bonding force, and such a conductive polymer layer can be uniformly formed to efficiently achieve the desired protective function. Furthermore, the polar functional group can also play a role in suppressing the PTC effect from occurring at relatively low temperatures.

The mole numbers of the polar functional group and the long-chain hydrocarbon functional group in the conductive polymer may be controlled to ensure an appropriate effect.

For example, the lower limit of the ratio (M_{L}/M_{P}) of the mole number (M_{L}) of the long-chain hydrocarbon functional group to the mole number (M_{P}) of the polar functional group in the conductive polymer may be 1, 5, 8, 10, 15, 16, 17, 18, or 19 or so, and the upper limit thereof may be 500, 450, 400, 350, 300, 250, 200, 150, 100, 95, 90, 85, 80, 75, 70, 65, 60, 55, 50, 45, 40, 35, 30, 25, 20, 15, or 10 or so. The ratio M_{L}/M_{P} may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The lower limit of the ratio (M_{A}/M_{B}) of the mole number (M_{A}) of the unit A to the mole number (M_{B}) of the unit B in the conductive polymer may be 1, 5, 8, 10, 15, 16, 17, 18, or 19 or so, and the upper limit thereof may be 500, 450, 400, 350, 300, 250, 200, 150, 100, 95, 90, 85, 80, 75, 70, 65, 60, 55, 50, 45, 40, 35, 30, 25, 20, 15, or 10 or so. The ratio M_{A}/M_{B} may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The lower limit of the ratio of the total mole number of the units A and B to the total mole number of all monomer units of the conductive polymer may be 50 mol%, 55 mol%, 60 mol%, 65 mol%, 70 mol%, 75 mol%, 80 mol%, 85 mol%, or 90 mol% or so, and the upper limit thereof may be 100 mol%, 95 mol%, 90 mol%, 85 mol%, 80 mol%, 75 mol%, 70 mol%, 65 mol%, or 60 mol% or so, relative to the mole number of all monomer units of the polythiophene. The ratio may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The specific structure of the monomer included in the conductive polymer is not particularly limited, if it is a thiophene monomer having the long-chain hydrocarbon functional group and/or polar functional group as described above.

For example, the conductive polymer may contain a unit of Formula 2 below as the thiophene unit.

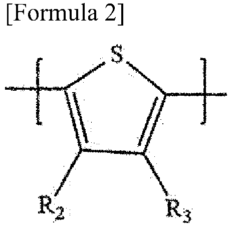

In Formula 2, R₂ and R₃ may each independently be hydrogen, the polar functional group, or the long-chain hydrocarbon functional group. In another example, R₂ and R₃ of Formula 2 may also be connected to each other to form a divalent functional group of Formula 3.

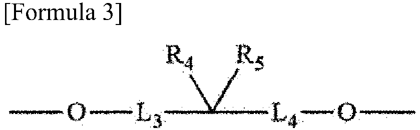

In Formula 3, L₃ and L₄ may each independently be a single bond, an alkylene group, or an alkylidene group, and R₄ and R₅ may each independently be hydrogen, the polar functional group, or the long-chain hydrocarbon functional group.

In Formula 2, when R₂ and R₃ are each independently hydrogen, a polar functional group, or a long-chain hydrocarbon functional group, at least one of R₂ and R₃ above may be the polar functional group or the long-chain hydrocarbon functional group.

In Formula 2, when R₂ and R₃ form the divalent functional group of Formula 3, at least one of R₄ and R₅ above may be the polar functional group or the long-chain hydrocarbon functional group.

In Formula 3, the meanings of the single bond, alkylene group, and alkylidene group, and specific examples are the same as in Formula 1.

The technical significance and specific examples of the long-chain hydrocarbon functional group and polar functional group in Formulas 2 and 3 are as described above.

The lower limit of the molar ratio of the unit of Formula 2 above based on all monomer units of the conductive polymer may be 50 mol%, 55 mol%, 60 mol%, 65 mol%, 70 mol%, 75 mol%, 80 mol%, 85 mol%, or 90 mol% or so, and the upper limit thereof may be 100 mol%, 95 mol%, 90 mol%, 85 mol%, 80 mol%, 75 mol%, 70 mol%, 65 mol%, or 60 mol% or so, relative to the mole number of all monomer units of the polythiophene. The ratio may be within a range of more than or equal to, or more than any lower limit arbitrarily selected from the above-listed lower limits; or within a range of less than, or equal to or less than any upper limit arbitrarily selected from the above-listed upper limits; or within a range of less than, or equal to or less than any upper limit arbitrarily selected from the above-listed upper limits simultaneously while being more than or equal to, or more than any lower limit arbitrarily selected from the above-listed lower limits.

In one example, the conductive polymer may contain a monomer unit represented by Formula 4 below. The monomer unit of Formula 4 may be one example of the monomer units having the first hydrocarbon functional group.

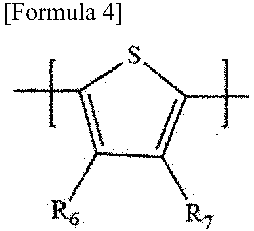

In Formula 4, R₆ and R₇ may each independently be hydrogen or the first hydrocarbon functional group. In this case, one or more of R₆ and R₇ above may be the first hydrocarbon functional group.

In another example, R₆ and R₇ above may be connected to each other to form a divalent functional group of Formula 5 below.

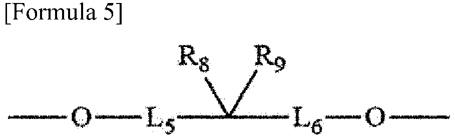

In Formula 5, L₅ and L₆ are each independently a single bond, an alkylene group, or an alkylidene group, and R₈ and R₉ are each independently hydrogen or the first hydrocarbon functional group, but at least one of R₈ and R₉ may be the first hydrocarbon functional group.

The specific details of the first hydrocarbon functional group are as described above, and the specific details of the single bond, alkylene group, or alkylidene group are as described in Formula 1 above.

The conductive polymer may also contain a monomer unit represented by Formula 6 below.

The monomer unit of Formula 6 above may be one example of the monomer units having the second hydrocarbon functional group.

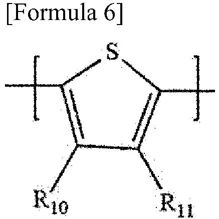

In Formula 6, R₁₀ and R₁₁ may each independently be hydrogen or the second hydrocarbon functional group, and in this case, one or more of R₁₀ and R₁₁ above may be the second hydrocarbon functional group.

In another example, R₁₀ and R₁₁ above may be connected to each other to form a divalent functional group of Formula 7 below.

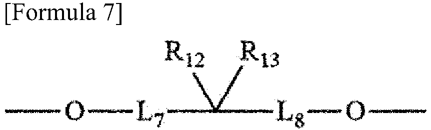

In Formula 7, L₇ and L₈ are each independently a single bond, an alkylene group, or an alkylidene group, and R₁₂ and R₁₃ are each independently hydrogen or the second hydrocarbon functional group, but at least one of R₁₂ and R₁₃ is the second hydrocarbon functional group.

The specific details of the second hydrocarbon functional group are as described above, and the specific details of the single bond, the alkylene group, and the alkylidene group are as described in Formula 1.

The conductive polymer may also contain a monomer unit represented by Formula 8 below. The monomer unit of Formula 8 may be one example of the monomer units having the polar functional group.

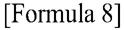

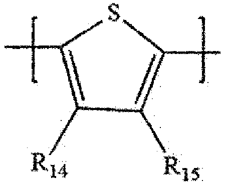

In Formula 8, R₁₄ and R₁₅ may each independently be hydrogen or the polar functional group. One or more of R₁₄ and R₁₅ above are the polar functional group.

In another example, R₁₄ and R₁₅ of Formula 8 above may be connected to each other to form a divalent functional group of Formula 9 below.

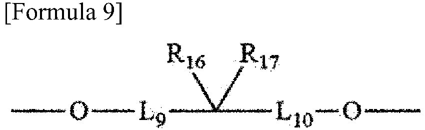

In Formula 9, L₉ and L₁₀ are each independently a single bond, an alkylene group, or an alkylidene group, and R₁₆ and R₁₇ are each independently hydrogen or the polar functional group, but at least one of R₁₆ and R₁₇ is the polar functional group.

The specific details of the polar functional group are as described above, and the specific details of the single bond, alkylene group, and alkylidene group are as described in Formula 1.

In the case where the conductive polymer simultaneously contains the monomer unit of Formula 4 above and the monomer unit of Formula 6 above, the ratio of the sum mole number of the monomer unit of Formula 4 above and the monomer unit of Formula 6 above to the mole number M of the total monomer units included in the conductive polymer may be adjusted within the same range as the molar ratio of the unit A as described above.

The ratio of the mole numbers of the monomer unit of Formula 4 above and the monomer unit of Formula 6 above may be adjusted within the same range as the ratio M1/M2 of the mole number as described above. At this time, the mole number M1 may be the mole number of the monomer unit of Formula 4 above, and the mole number M2 may be the mole number of the monomer unit of Formula 6 above.

When the conductive polymer contains the monomer unit of Formula 8 above, the unit may be included in a range which is within the range of the molar ratio M_{A}/M_{B} as described above. In this instance, the mole number of the monomer unit of Formula 8 above becomes the mole number M_{B}. In addition, the mole number M_{A} may be the mole number of the monomer unit of Formula 4 above, the mole number of the monomer unit of Formula 6 above, or the sum mole number of the monomer unit of Formula 4 above and the monomer unit of Formula 6 above.

When the monomer units of Formulas 4, 6 and 8 above are present in the conductive polymer, the lower limit of the ratio of the total mole number of the monomer units of Formulas 4, 6 and 8 above to the total mole number of all monomer units in the conductive polymer may be 50 mol%, 55 mol%, 60 mol%, 65 mol%, 70 mol%, 75 mol%, 80 mol%, 85 mol%, or 90 mol% or so, and the upper limit thereof may be 100 mol%, 95 mol%, 90 mol%, 85 mol%, 80 mol%, 75 mol%, 70 mol%, 65 mol%, or 60 mol% or so, relative to the mole number of all monomer units of the polythiophene. The ratio may be within a range of more than or equal to, or more than any lower limit arbitrarily selected from the above-listed lower limits; or within a range of less than, or equal to or less than any upper limit arbitrarily selected from the above-listed upper limits; or within a range of less than, or equal to or less than any upper limit arbitrarily selected from the above-listed upper limits simultaneously while being more than or equal to, or more than any lower limit arbitrarily selected from the above-listed lower limits.

The conductive polymer may further contain other monomer units, if the above-described units are included in the above ratios. The polymer layer comprises the conductive polymer, and accordingly, it is possible to exhibit the above-described properties.

The conductive polymer may further contain other monomer units, if the above-described units are included in the above ratios.

The polymer layer may comprise a conductive material together with the conductive polymer.

As the conductive material, any material having appropriate conductivity may be used. For example, as the conductive material, one, or two or more selected from carbon particles, carbon fibers, graphene, graphite, carbon black, carbon nanotubes, and metal particles, and the like may be used.

As the conductive material, an appropriate type may be selected and used from the above-described types, and the form of the material may be in the form of particles (spherical, irregular, or other shapes), plates, or fibers, and the like, but is not limited thereto.

The size of the conductive material may also be appropriately adjusted as needed. For example, the lower limit of the size of the conductive material may be 10 nm, 50 nm, 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, 5000 nm, or 10000 nm or so, and the upper limit thereof may also be 100000 nm, 90000 nm, 80000 nm, 70000 nm, 60000 nm, 50000 nm, 40000 nm, 30000 nm, 20000 nm, 10000 nm, 5000 nm, 1000 nm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, 200 nm, 200 nm or 150 nm, 100 nm, 90 nm, 80 nm, 70 nm, or 65 nm or so. The size may be more than or equal to, or more than any lower limit arbitrarily selected from the above-listed lower limits, or may be less than or equal to, or less than any upper limit arbitrarily selected from the above-listed upper limits, or may have a range of less than or equal to, or less than any upper limit arbitrarily selected from the above-listed upper limits while being more than or equal to, or more than any lower limit arbitrarily selected from the above-listed lower limits. When the conductive material is in the form of particles, the size may be the average diameter (so-called D50 particle diameter); when it is in the form of plates, it may be the thickness, long side, or cross-section; and when it is in the form of fibers, it may be the diameter or length of the cross-section.

When the conductive material is in the form of fibers, the lower limit of the aspect ratio (length/cross-sectional diameter) may be 5, 10, 15, 20, 25, 30, 35, 40, 45, 50, 55, 60, or 65 or so, and the upper limit thereof may be 200, 195, 190, 185, 180, 175, 170, 165, 160, 155, 150, 145, 140, 135, 130, 125, 120, 115, 110, 105, 100, 95, 90, 85, 80, 75, or 70 or so. The aspect ratio may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

If necessary, the conductive material may be surface-treated in consideration of dispersibility, and the like.

In this case, a conductive core and a surface layer present on the surface of the core may be included. In this case, the conductive material, which is one, or two or more selected from the carbon particles, carbon fibers, graphene, graphite, carbon black, carbon nanotubes, and metal particles, and the like, becomes the conductive core.

A surface-treating agent having appropriate compatibility with the conductive polymer may be used as the surface-treating agent. For example, the conductive material may be surface-treated with a polyphenol-based compound as the surface-treating agent. In this case, the surface layer may comprise the polyphenol-based compound. The polyphenol-based compound means a compound including a structure containing two or more hydroxy groups which are substituted in benzene, and connected thereto. Such a compound may be exemplified by a so-called catechol compound (i.e., catechol, or compound including the relevant structure), and an example thereof includes dopamine, polydopamine, 3,4-dihydroxy phenyl alanine, norepinephrine, tannic acid, humic acid, and/or lignin, and the like, but is not limited thereto.

The method of surface-treating the conductive material with the surface-treating agent is not limited, and for example, a method of mixing the conductive material and the surface-treating agent in an appropriate solvent, and the like, or a method of synthesizing or polymerizing the surface-treating agent on the surface of the conductive material may be applied.

When the conductive material is used, the ratio of the conductive material within the polymer layer may be adjusted depending on the purpose (e.g., the desired oxidation potential). For example, the lower limit of the weight ratio of the conductive material in the polymer layer may be 1 part by weight, 5 parts by weight, 10 parts by weight, 15 parts by weight, 20 parts by weight, 25 parts by weight, 30 parts by weight, 35 parts by weight, 40 parts by weight, 42 parts by weight, 44 parts by weight, 46 parts by weight, 48 parts by weight, 50 parts by weight, 52 parts by weight, 54 parts by weight, 56 parts by weight, 58 parts by weight, 60 parts by weight, 65 parts by weight, 70 parts by weight, 75 parts by weight, 80 parts by weight, 85 parts by weight, 90 parts by weight, 95 parts by weight, or 100 parts by weight or so, relative to 100 parts by weight of the conductive polymer, and the upper limit thereof may be, for example, 1,000 parts by weight, 950 parts by weight, 900 parts by weight, 850 parts by weight, 800 parts by weight, 750 parts by weight, 700 parts by weight, 650 parts by weight, 600 parts by weight, 550 parts by weight, 500 parts by weight, 450 parts by weight, 400 parts by weight, 350 parts by weight, 300 parts by weight, 250 parts by weight, 200 parts by weight, 150 parts by weight, 145 parts by weight, 140 parts by weight, 135 parts by weight, 130 parts by weight, 125 parts by weight, 120 parts by weight, 115 parts by weight, 110 parts by weight, 105 parts by weight, 100 parts by weight, 95 parts by weight, 90 parts by weight, 85 parts by weight, 80 parts by weight, 75 parts by weight, 70 parts by weight, 65 parts by weight, 60 parts by weight, 55 parts by weight, 50 parts by weight, 45 parts by weight, 40 parts by weight, 35 parts by weight, 30 parts by weight, or 25 parts by weight or so. The content may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

Under such a ratio, the conductive material appropriately interacts with the conductive polymer, thereby enabling a polymer layer in a desired shape to be effectively formable.

For example, the conductive material can exhibit effects of adjusting the oxidation potential of the polymer layer and improving the electrical reactivity of the relevant polymer layer.

The polymer layer may also comprise any additional components, if it comprises the conductive polymer and the conductive material.

The thickness of the polymer layer may be appropriately controlled depending on the purpose. For example, the lower limit of the thickness of the polymer layer may be 10 nm, 50 nm, 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, or 1000 nm or so, and the upper limit thereof may be 2 µm, 1.5 µm, 1 µm, 950 nm, 900 nm, 850 nm, 800 nm, 750 nm, 700 nm, 650 nm, 600 nm, 550 nm, 500 nm, 450 nm, 400 nm, 350 nm, or 300 nm or so. The thickness may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The polymer layer may be manufactured in the manner to be described below.

For example, a method for manufacturing the polymer layer may comprise, for example, a first step of forming a precursor comprising a conductive polymer and a conductive material, and a step of heat-treating the precursor.

As the conductive polymer and conductive material used for forming the precursor, the conductive polymer and conductive material as described above may be used. The conductive polymer, and the like may be produced by a known method, or the obtained commercially available product may be used. For example, as the method for producing polythiophene, a method of using an oxidation polymerization reaction, a method of using a radical reaction, or the like is known, where such a method may also be applied to the process of forming the conductive polymer. In addition, a commercially available product may also be used as the conductive material, and its surface treatment may also be performed in a known manner.

The precursor is, for example, a layer comprising the conductive polymer and conductive particles, which ultimately means a layer that becomes the polymer layer.

Such a precursor may be formed in a known manner, and for example, it may be formed in a manner of coating a polymer solution in which the conductive polymer, and the like are dispersed in an appropriate solvent.

As the solvent, an appropriate solvent capable of dispersing the conductive polymer and the conductive material may be selected, and for example, an ether-based solvent such as diethyl ether, tetrahydrofuran, dioxane, trioxane, dimethoxy ethane, or toluene; an aromatic hydrocarbon-based solvent such as ethyl benzene, or an alicyclic hydrocarbon solvent such as cyclohexane; or a tertiary amine-based solvent such as tetramethylethylenediamine (TMEDA) or hexamethylphosphorictriamide (HMPA), or the like may be used, or a mixed solvent including two or more of the foregoing, and the like may be used, but is not limited thereto.

The polymer solution is used to form a precursor. This process may usually be performed through a process of coating the polymer solution on an appropriate process base material. In this instance, the coating method is not particularly limited.

The manufacturing method further comprises a step of heat-treating the precursor of the polymer layer. By adjusting the conditions in this process, the orientation state of the conductive polymer (e.g., orientation state of the long-chain hydrocarbon functional group and/or polar functional group) and/or the dispersion state of the conductive material is adjusted or stabilized, whereby it is possible to form a polymer layer satisfying the intended PTC effect, oxidation potential characteristics, and other characteristics.

The heat-treating step may be performed in two steps. For example, the heat-treating step may comprise a second step of primarily heat-treating the precursor of the first step at a temperature range T₁; and a third step of secondarily heat-treating the precursor at a temperature range T₂, following the second step.

For accomplishment of the orientation or alignment of the conductive polymer and the dispersion state of the conductive material, the conditions of the second and third steps may be adjusted.

For example, the temperature range T₁ of the primary heat treatment may be adjusted within a predetermined range. For example, the lower limit of the temperature range T₁ may be 50°C, 55°C, 60°C, 65°C, 70°C, 75°C, 80°C, 85°C, 90°C, 95°C, 100°C, 105°C, 110°C, 115°C, 120°C, 125°C, 130°C, 135°C, or 140°C or so, and the upper limit thereof may be 300°C, 290°C, 280°C, 270°C, 260°C, 250°C, 240°C, 230°C, 220°C, 210°C, 200°C, 190°C, 180°C, 170°C, 160°C, 150°C, or 140°C or so. The temperature range T₁ may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

In the heat-treating step, the temperature range T₁ of the primary heat treatment and the temperature range T₂ of the secondary heat treatment may be adjusted. For example, the lower limit of the ratio (T₁/T₂) of the temperature ranges T₁ and T₂ may be 0.1, 0.2, 0.3, 0.4, 0.5, 0.6, 0.7, 0.8, 0.9, 1, 1.1, or 1.2 or so, and the upper limit thereof may be 5, 4.5, 4, 3.5, 3, 2.5, 2, 1.9, 1.8, 1.7, 1.6, 1.5, 1.4, 1.3, 1.2, or 1.1 or so. The ratio may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

In one example, the temperature range T₁ of the primary heat treatment in the heat-treating step may be adjusted to be higher than the temperature range T₂ of the secondary heat treatment.

The ratio of the heat treatment time M₁ in the primary heat treatment and the heat treatment time M₂ in the secondary heat treatment may be further adjusted. For example, the lower limit of the ratio M₂/M₁ may be 1, 2, 3, 4, 5, 6, 7, 8, 9, 10, 11, 12, 13, 14, 15, 20, 50, 70, 100, 110, 120, 130, 140, 150, 160, 170, 180, 190, 200, 210, 220, 230, 240, 250, 260, or 270 or so, and the upper limit thereof may be 1,000, 950, 900, 850, 800, 750, 700, 650, 600, 550, 500, 450, 400, 350, 300, 290, 280, 270, 250, 200, 150, 100, 90, 80, 70, 60, 50, 40, 30, or 20 or so. The ratio M₂/M₁ may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The lower limit of the secondary heat treatment time M₂ may be 0.1 hours, 0.2 hours, 0.3 hours, 0.4 hours, 0.5 hours, 0.6 hours, 0.7 hours, 0.8 hours, 0.9 hours, 1 hour, 2 hours, 3 hours, 4 hours, 5 hours, 6 hours, 7 hours, 8 hours, 9 hours, 10 hours, 11 hours, 12 hours, 13 hours, 14 hours, 15 hours, 16 hours, 17 hours, or 18 hours or so, and the upper limit thereof may be 50 hours, 48 hours, 46 hours, 44 hours, 42 hours, 40 hours, 38 hours, 36 hours, 34 hours, 32 hours, 30 hours, 28 hours, 26 hours, 24 hours, 22 hours, 20 hours, 18 hours, 15 hours, 10 hours, 9 hours, 8 hours, 7 hours, 6 hours, 5 hours, 4 hours, 3 hours, 2 hours, 1.5 hours, or 1 hour or so. The secondary heat treatment time M₂ may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The polymer layer may be formed through the above processes.

Through this heat treatment process, the orientation state of the conductive polymer (e.g., orientation state of the long-chain hydrocarbon functional group and/or polar functional group) and/or the dispersion state of the conductive material is adjusted or stabilized, whereby it is possible to form a polymer layer satisfying the intended PTC effect, oxidation potential characteristics, and other characteristics.

As the current collectors for the positive and negative electrodes, those commonly used as current collectors for positive or negative electrodes may be used without any special limitations.

If the current collector has conductivity without causing chemical changes in applied devices such as secondary batteries, the type, size, and shape thereof, and the like are not particularly limited. An example of a material that can be used as the current collector may be exemplified by a material, and the like in which the surface of copper, aluminum, or stainless steel is surface-treated with carbon, nickel, titanium, or silver, and the like. The current collector may be in the form of a film, sheet, foil, net, porous body, foam, or non-woven fabric, and the like, which comprises the above material. In some cases, a known surface treatment may also be performed on the surface of the current collector to improve adhesive force to other layers such as a polymer layer or an active material layer.

The current collector typically has a thickness in a range of 3µm to 500 µm, but is not limited thereto.

As the active material layer used to form the electrode, a commonly applied layer may also be used. Typically, the active material layer comprises an electrode active material. The specific type of the electrode active material is not particularly limited, and materials to form a positive electrode or a negative electrode may usually be used.

For example, when the active material layer is a positive electrode active material layer, the electrode active material may include layered compounds such as lithium cobalt oxide (LiCoO₂) or lithium nickel oxide (LiNiO₂), or compounds substituted with one or more transition metals; lithium iron oxides such as LiFe₃O₄; lithium manganese oxides such as Formula Li_{1+c1}Mn_{2-c1}O₄ (0≤c1≤0.33), LiMnO₃, LiMn₂O₃, or LiMnO₂; lithium copper oxides (Li₂CuO₂); vanadium oxides such as LiV₃O₈, V₂O₅, or Cu₂V₂O₇; Ni-site lithium nickel oxides represented by Formula LiNi_{1-c2}M_{c2}O₂ (where M is at least one selected from the group consisting of Co, Mn, Al, Cu, Fe, Mg, B and Ga, and 0.01≤c2≤0.3 is satisfied); lithium manganese composite oxides represented by Formula LiMn_{2-c3}M_{c3}O₂ (where M is at least one selected from the group consisting of Co, Ni, Fe, Cr, Zn, and Ta, and 0.01≤c3≤0.1 is satisfied) or Li₂Mn₃MO₈ (here, M is at least one selected from the group consisting of Fe, Co, Ni, Cu and Zn); lithium nickel cobalt manganese (NCM) composite oxides, lithium nickel cobalt manganese aluminum (NCMA) composite oxides, and LiMn₂O₄ in which a part of Li in the formula is substituted with alkaline earth metal ions, and the like, but is not limited thereto.

When the active material layer is a negative electrode active material layer, as the electrode active material, for example, a compound capable of reversible intercalation and deintercalation of lithium may be used. A specific example may include carbonaceous materials such as artificial graphite, natural graphite, graphitized carbon fiber, and amorphous carbon; metallic compounds capable of alloying with lithium, such as Si, Al, Sn, Pb, Zn, Bi, In, Mg, Ga, Cd, Si alloy, Sn alloy, or Al alloy; metal oxides capable of doping and de-doping lithium, such as SiOₐ (0 < a < 2), SnO₂, vanadium oxide, and lithium vanadium oxide; or a composite comprising the metallic compound and the carbonaceous materials such as a Si-C composite or a Sn-C composite, and the like, and any one or a mixture of two or more of the foregoing may be used.

A metal lithium thin film may also be used as the negative electrode active material, and as the carbon material, low crystalline carbon and high crystalline carbon, and the like may also be used. As the low crystalline carbon, soft carbon and hard carbon are representative, and as the high crystalline carbon, high-temperature baked carbons such as amorphous, plate-like, scale-like, spherical, or fibrous natural graphite or artificial graphite, Kish graphite, pyrolytic carbon, mesophase pitch based carbon fiber, mesocarbon microbeads, mesophase pitches, and petroleum and coal tar pitch derived cokes are representative.

The electrode active material may be included in the active material layer within a range of about 80 weight% to 99.5 weight%, or within a range of 88 weight% to 99 weight%, relative to the total weight of the active material layer, but the ratio may be changed depending on the use or design of the electrode.

The active material layer may further comprise a binder. The binder serves to improve attachment between the active materials, and adhesive force on between the active material layer and the current collector. An example of the binder is not particularly limited, and one or more may be selected from the group consisting of, for example, PVDF (poly(vinylidene fluoride), PVA (poly(vinyl alcohol)), SBR (styrene butadiene rubber), PEO (poly(ethylene oxide)), CMC (carboxyl methyl cellulose), cellulose acetate, cellulose acetate butylate, cellulose acetate propionate, cyanoethylpullulan, cyanoethyl polyvinyl alcohol, cyanoethyl cellulose, cyanoethyl sucrose, pullulan, polymethylmethacrylate, polybutylacrylate, polyacrylonitrile, polyvinylpyrrolidone, polyvinylacetate, an ethylene vinyl acetate copolymer (polyethylene-co-vinyl acetate), and polyarylate, and used.

In one example, the binder may be included in the active material layer within a range of 0.1 parts by weight to 10 parts by weight or 0.5 parts by weight to 5 parts by weight, relative to 100 parts by weight of the electrode active material, but is not limited thereto.

The active material layer may further comprise a conductive material, as needed. If the conductive material has conductivity without causing chemical changes in the secondary battery, it is not particularly limited, any known material can be used. For example, graphite such as natural graphite or artificial graphite; carbon black, such as carbon black, acetylene black, Ketjen black, channel black, furnace black, lamp black, or thermal black; conductive fibers such as carbon fibers or metal fibers; conductive tubes such as carbon nanotubes (CNTs); metal powders such as fluorocarbon, aluminum, or nickel powder; conductive whiskers such as zinc oxide or potassium titanate; conductive metal oxides such as titanium oxide; conductive materials such as polyphenylene derivatives, and the like may be used.

In one example, the conductive material may be included in the active material layer in an amount of 0.1 parts by weight to 20 parts by weight or 0.3 parts by weight to 10 parts by weight, relative to 100 parts by weight of the electrode active material, but is not limited thereto.

The active material layer may also further comprise any necessary known components in addition to the above-described components optionally.

The method for forming the active material layer on the polymer layer to manufacture an electrode is not particularly limited. Typically, the active material layer is formed by coating a slurry containing the electrode active material, a binder, and a conductive material, and the like on the current collector (on the polymer layer), drying, and then rolling, and such a known method may also be applied to the present application in the same manner.

The electrode assembly may be formed using the positive and negative electrodes formed in the above manner and the above-described separator.

The present specification also discloses an electrochemical element, such as a secondary battery, comprising the electrode assembly. The electrochemical element is not particularly limited in terms of other components or manufacturing methods, if the electrode assembly is used, and known methods may be applied.

### Advantageous Effects

The present specification discloses an electrode assembly and a secondary battery. The present specification discloses an electrode assembly formed by combining: an electrode capable of exhibiting low resistance and excellent electrical characteristics in a normal state of a secondary battery, and securing stability by being rapidly converted into an insulator in an abnormal state thereof; and a separator which is referred to as a so-called SRS (safety-reinforcing separator). The present specification also discloses a secondary battery comprising the electrode assembly.

### Description of Drawings

Figure 1 is a side view of an exemplary electrode assembly.
Figure 2 is a side view of an exemplary separator.
Figure 3 is a side view of an exemplary electrode.
Figure 4 is an NMR analysis result of a compound manufactured in a preparation example.
Figure 5 is an SEM image of an electrode of an example.
Figure 6 is analysis results for a coin half-cell of Test Example 1.
Figure 7 is charge and discharge profiles of cycle tests of Test Example 1.
Figure 8 is energy density retention (140 cycles) results of Test Example 1.
Figure 9 is rate test results of a 3-Ah pouch cell of Test Example 1.
Figure 10 is cycle test results of a 3-Ah pouch cell of Test Example 1.
Figure 11 is a diagram for explaining a method of performing an impact test.
Figure 12 is a view showing a maximum temperature and temperature rise rates in an impact test.

### Mode for Invention

Hereinafter, the electrode assembly, and the like is described in detail through examples and comparative examples, but the scope of the electrode assembly, and the like is not limited by the following examples.

### 1. NMR analysis

¹H-NMR analyses were performed at room temperature (25°C) using an NMR spectrometer (including a Bruker UltraShield spectrometer (300 MHz)) with a 5 mm triple resonance probe. A sample was diluted in a solvent (CDCl₃) for NMR measurement to a concentration of about 10 mg/ml or so and used, and the chemical shift was expressed in ppm.

### 2. GPC (Gel Permeation Chromatograph)

Molecular weight characteristics were measured using GPC (Gel permeation chromatography). A sample is placed in a 5 mL vial and diluted with chloroform to a concentration of 1 mg/mL or so. The standard sample for calibration and an analytical sample were filtered through a syringe filter (pore size: 0.45 µm), and then the measurement was performed. As the analysis program, Waters' Empower 3 was used, and a weight average molecular weight (Mw) and a number average molecular weight (Mn) were each obtained by comparing the elution time of the sample with the calibration curve. The molecular weight distribution (PDI) is equivalent to a value Mw/Mn obtained by dividing the weight-average molecular weight Mw by the number-average molecular weight Mn. The GPC measurement conditions are as follows.

### <GPC measurement conditions>

Instrument: Waters' 2414
Column: using 3 Styragels from Waters
Solvent: THF (tetrahydrofuran)
Column temperature: 35°C
Sample concentration: 1 mg/mL, 1 µL injection
Standard sample: polystyrene (Mp: 3900000, 723000, 316500, 52200, 31400, 7200, 3940, 485)

### 3. Thickness measurement

A cross-section of a thickness measurement target was exposed using an ion milling device (Hitachi, IM5000), and then, a Scanning Electron Microscope (SEM) (JEOL, JSM-7200F) image of the cross-section was captured, and a thickness was obtained from the image. The cross-section exposure was performed using the ion milling equipment (Hitachi, IM5000) in a cross-section milling mode under conditions of a speed (reciprocation/min) of 3, an acceleration voltage of 6 kD, a discharge voltage of 15 kV, and a current of 150 µA, with setting a time of 4 hours. The SEM (Scanning Electron Microscope) (JEOL, JSM-7200F) image was magnified within a range of 500 times to 20,000 times, and captured under a voltage condition of 5kV.

### 4. Measurement of polymer layer oxidation potential

A polymer layer is formed on an aluminum foil (Al Foil) with a thickness of about 15 µm. The polymer layer is formed in the manner described in each example or comparative example, which is formed to have a thickness of 10 µm or so. A separator and a lithium film (thickness: about 100 µm) are laminated on the polymer layer to manufacture a laminate (Al Foil/polymer layer/separator/lithium film). The laminate is punched into a circle with a diameter of about 1.4 cm. A coin cell is manufactured using the punched laminate and an electrolyte. The coin cell is manufactured using Wellcos' CR2032 coin cell kit. As the separator, W-Scope Korea's WL20C model is used. As the electrolyte, Enchem's product (1M LiPF₆ solution (solvent: EC/DMC/EMC=3/4/3 (mass ratio), EC: ethylene carbonate, DMC: dimethyl carbonate, EMC: ethylmethyl carbonate)) is used. An oxidation potential of the coin cell is measured at 25°C using a potentiostat (Princeton Applied Research, PARASTAT-MC). A CV (cyclic voltammetry) analysis is performed at a scan rate of 0.17 to 0.5 mV/sec in a range of 1.5V to 5.5V, from which the oxidation potential (based on Li/Li⁺) is identified.

### 5. Measurement of electrode active material oxidation potential

An electrode active material (A), a conductive material (B) (ECP (Ketjen Black) 0.5%, SFG (Trimrex graphite) 0.4%, DB (Denka Black) 0.4%), PVDF (C) (poly(vinylidene fluoride)), and NMP (D) (N-methyl-2-pyrrolidone) are formulated in a weight ratio of 75:1:1:23 (A: B: C: D) to prepare a slurry. The slurry is applied onto a current collector with a doctor blade, dried at room temperature (about 25°C), and then maintained in a drying oven at 130°C for 30 minutes or so, and rolled to form an active material layer with a thickness of about 53 µm or so, thereby manufacturing an electrode. The rolling is performed so that the active material layer has a porosity of about 25% or so. The porosity of the active material layer is a value calculated by a method of comparing the ratio of the difference between the actual density and the density after rolling, and the method of obtaining the porosity in such a method is well known. An aluminum foil (Al foil) with a thickness of 15µm or so is used as the current collector.

A separator and a lithium film (thickness: about 100 µm) are laminated on the electrode active material layer to form a laminate (electrode/separator/lithium film), and the laminate is punched into a circle with a diameter of about 1.4 cm or so. A coin cell is manufactured using the punched laminate and an electrolyte. The coin cell is manufactured using Wellcos' CR2032 coin cell kit. The separator and electrolyte are the same as those used in "4. Measurement of polymer layer oxidation potential" above.

The oxidation potential of the coin cell is measured at 25°C using a potentiostat (Princeton Applied Research, PARASTAT-MC).

A CV (cyclic voltammetry) analysis is performed at a scan rate of 0.17 mV/sec to 0.5 mV/sec in a range of 1.5V to 5.5V, from which the oxidation potential (based on Li/Li⁺) is identified.

### 6. DC resistance measurement method

DC resistance was evaluated using the coin cell used in "4. Measurement of polymer layer oxidation potential." A voltage of 4.3eV was applied to the coin cell for 10 minutes at room temperature (25°C), and the DC resistance was measured using a Fluke digital multi-tester (FLUKE-87-5).

### 7. AC impedance resistance

AC impedance resistance was evaluated through EIS (Electrochemical Impedance Spectronization) using the coin cell used in "4. Measurement of polymer layer oxidation potential." A voltage of 4.3V was applied to the coin cell for 10 minutes at room temperature (25°C), and a Nyquist plot was obtained by an EIS measurement method at 50,000 Hz to 0.1 Hz, and the AC impedance resistance obtained in the high frequency region was measured. A potentiostat (Princeton Applied Research, PARASTAT-MC) was used as the EIS measurement device.

### 8. Measurement of maximum resistance change rate (DC resistance)

A maximum resistance change rate ΔR1 is determined according to Equation 3 below. <Equation 1> $ΔR 1 = Max \left\{\left({R}_{n + 5}/{R}_{n}\right)/5\right\}$

In Equation 3, Rₙ is the DC resistance at any temperature (n°C) within the range of 25°C to 135°C, and Rₙ₊₅ is the DC resistance at a temperature ((n+5)°C) that is 5°C higher than the temperature.

The above ΔR1 is measured in the following manner.

A coin cell for measuring DC resistance (same as used in "6. DC resistance measurement method") is placed in the center of a convection oven (Jeotech, OF3-05W). The conditions of the convection oven are set to an initial temperature of 25°C, a final temperature of 135°C, and a heating rate of 5°C/1 min. The coin cell is connected to a resistance measurement multimeter (Fluke's digital multi-tester (FLUKE-87-5)) outside the convection oven. The DC resistance is measured at each temperature in a state where the temperature increases, as set (measurement up to 135°C while increasing the measurement temperature by 5°C in the order of 25°C, 30°C, 35°C, and 40°C). Rₙ and Rₙ₊₅ of Equation 3 for each measurement temperature are each measured, Rₙ₊₅/Rₙ (R₃₀/R₂₅, R₃₅/R₃₀ ~ R₁₃₅/R₁₃₀) are each calculated, and then they are divided by 5 again. After obtaining the above (Rₙ₊₅/Rₙ)/5 in the temperature range of 25°C to 135°C, the maximum value among them is defined as the above ΔR1. The temperature n°C at which (Rₙ₊₅/Rₙ)/5 reaches its maximum value is defined as the on-set temperature.

### 9. Measurement of maximum resistance change rate (AC impedance)

The maximum resistance change rate ΔR2 is determined according to Equation 4 below. <Equation 4> $ΔR 2 = Max \left\{\left({R}_{z + 5}/{R}_{z}\right)/5\right\}$

In Equation 4, R_{z} is the AC impedance resistance at an arbitrary temperature (z°C) within the range of 25°C to 135°C, and R_{z+5} is the AC impedance resistance at a temperature ((z+5)°C) that is 5°C higher than the temperature.

The above ΔR2 is measured in the following manner.

A coin cell for measuring AC impedance resistance (same as used in "7. AC impedance resistance") is placed in the center of a convection oven (Jeotech, OF3-05W). The convection oven is set to have an initial temperature of 25°C, a final temperature of 135°C, and a heating rate of 5°C/1 min. The coin cell is connected to a potentiostat (Princeton Applied Research, PARASTAT-MC) outside the oven. The AC impedance resistance is measured at each temperature in a state where the temperature increases, as set (measurement up to 135°C while increasing the measurement temperature by 5°C in the order of 25°C, 30°C, 35°C, and 40°C). R_{z} and R_{z+5} of Equation 4 for each measurement temperature are each measured, and R_{z+5}/R_{z} (R₃₀/R₂₅, R₃₅/R₃₀ ~ R₁₃₅/R₁₃₀) are calculated and then they are divided by 5 again. After obtaining each the above (R_{z+5}/R_{z})/5 in the temperature range of 25°C to 135°C, the maximum value among them is obtained as the above ΔR2. The temperature z°C at which (R_{z+5}/R_{z})/5 reaches its maximum value is designated as the on-set temperature. The AC impedance resistance was determined as the resistance obtained from the semicircle in the high frequency region by applying a voltage of 4.3V for 10 minutes, and obtaining a Nyquist plot using the EIS measurement method at 50,000 Hz to 0.1 Hz.

### 10. Charge and discharge test

A charge-and-discharge test was evaluated on a coin cell manufactured using a CR2032 standard coin cell kit (Wellcos). The electrode manufactured in each example or comparative example was used as the positive electrode, and a lithium film (thickness: about 100 µm) was used as the negative electrode. The electrolyte and separator were the same as those used in "4. Measurement of polymer layer oxidation potential" above. A charge-and-discharge test was performed using the coin cell, and the test was performed using the constant current-constant voltage (CC-CV) method, which was performed using the charge and discharge conditions as 0.1C/0.1C (Condition 1), 0.5C/0.1C (Condition 2), 0.5C/0.5C (Condition 3), 0.5C/1C (Condition 4), and 0.5C/2C (Condition 5), respectively.

### 11. High-temperature discharge capacity reduction rate

For the same coin cell used in "10. Charge and discharge test," one charge-and-discharge at 25°C was practiced, and the capacity at 0.2C was measured as the roomtemperature discharge capacity (C25). The one charge-and-discharge was performed by a method of charging it in a CC (Constant Current)/CV (Constant Voltage) manner at a rate of 0.2C under conditions of a final charging voltage of 4.5V and a final charging current of 1mA, and discharging it in a CC (Constant Current) manner at a rate of 0.2C under a condition of a final discharging voltage of 3.0V.

The coin cell was maintained at 130°C for 10 minutes or so, and then a high-temperature discharge capacity (C130) was obtained. The following charge-and-discharge (1 cycle) was repeated 30 times (30 cycles) for the coin cell maintained at the high temperature, and then the discharge capacity was applied as the high-temperature discharge capacity (C130). The 30 charge-and-discharge cycles were performed at 45°C.

Charge-and-discharge (1 cycle): charging it in a CC (Constant Current)/CV (Constant Voltage) manner at a rate of 0.5C under conditions of a final charging voltage of 4.5V and a final charging current of 1mA, and then discharging it in a CC (Constant Current) manner at a rate of 2C under a condition of a final discharging voltage of 3.0V.

### 12. Measurement of oxidation potentials Vᵢ and V_{f}

Oxidation potentials Vᵢ and V_{f} are measured in the following manner. A polymer layer is formed on an aluminum foil (Al Foil) (thickness: about 15 µm). The formation method and thickness of the polymer layer are applied in the same manner as in each example or comparative example. A separator and a lithium film (thickness: about 100 µm) are laminated on the polymer layer to manufacture a laminate in which Al foil/polymer layer/separator/lithium film are laminated. The laminate is punched into a circle with a diameter of about 1.4 cm. A coin cell is manufactured using the circle-punched laminate and an electrolyte. The coin cell is manufactured using Wellcos' CR2032 coin cell kit. Upon manufacturing of the coin cell, LG Energy Solution's SRS (safety-reinforcing separator) is used as the separator. The SRS is a separator in which an inorganic particle layer including PVDF-HFP (poly(vinylidene fluoride-co-hexafluoropropylene)) and Al₂O₃ is formed on a polymer membrane (polyethylene separator) (a porosity degree of about 45%), and the weight ratio (PVdF-HFP: Al₂O₃) of PVDF-HFP and Al₂O₃ is about 1:4 or so. The same electrolyte as that used in "4. Measurement of polymer layer oxidation potential" above is used. The oxidation potential of the coin cell is measured using a potentiostat (Princeton Applied Research, PARASTAT-MC) at 25°C. CV (Cyclic Voltammetry) is performed 10 times at a scan rate of 0.83 mV/sec in a range of 3V to 4.5V. The oxidation potential identified after performing the CV once is designated as Vᵢ, and the oxidation potential identified after performing the CV 10 times is designated as V_{f}.

### 13. AC impedance resistance measurement at 3V and 3.5V

### Sample manufacturing

A polymer layer was formed on a 15 µm-thick aluminum foil (Al Foil). The formation method and thickness of the polymer layer were the same as those described in each example or comparative example. A separator and a lithium film were laminated on the polymer layer to manufacture a laminate in which the Al Foil/polymer layer/separator/lithium film were laminated, and the laminate was punched into a circular shape with a diameter of about 1.4 cm. A coin cell was manufactured using the punched laminate and an electrolyte (using Wellcos' CR2032 coin cell kit), and impedance was measured using this coin cell. As the separator, the above-described SRS was used; as the lithium film, a lithium film with a thickness of 300 µm or so was used; and as the electrolyte, the same one as that used in "4. Measurement of polymer layer oxidation potential" above was used.

### External voltage 3V condition

For the coin cell, AC impedance resistance was measured in an EIS (Electrochemical Impedance Spectronization) manner. A voltage of 3V was applied to the coin cell at room temperature (25°C) for 10 minutes, and the resistance R_{3V} was measured, which was obtained in the high-frequency region of a Nyquist plot obtained using the EIS measurement method in a range of 50,000 Hz to 0.1 Hz. A potentiostat (Princeton Applied Research, PARASTAT-MC) was used as the EIS measurement device.

### External voltage 3.5V condition

The external voltage applied to the coin cell for which the resistance R_{3V} was measured was converted to 3.5V, and after 1 second, the AC impedance resistance R_{3.5V} was measured in the same manner.

### 14. AC impedance resistance measurement at room temperature (25°C) and 130°C

For the coin cell (same as used in "13. AC impedance resistance measurement at 3V and 3.5V"), AC impedance resistance was measured in an EIS (Electrochemical Impedance Spectronization manner. Specifically, the resistance was measured, which was obtained in a high-frequency region of a Nyquist plot obtained by the EIS measurement method in a range of 50,000 Hz to 0.1 Hz. A potentiostat (manufacturer: Princeton Applied Research, product name: PARASTAT-MC) was used as the EIS measurement device. A voltage of 4.5V was applied to the coin cell at room temperature (25°C) for 10 minutes, and then the AC impedance resistance R₂₅ was measured after about 1 minute in a state where the external voltage was set to 0V (open circuit voltage).

Separately, the coin cell was placed in the center of a convection oven (Jeotech, OF3-05W), and the oven was set to a final temperature of 130°C. The coin cell was connected to a potentiostat (Princeton Applied Research, PARASTAT-MC) outside the oven to enable EIS resistance measurement. The external voltage was maintained at 0V (open circuit voltage). The AC impedance resistance R₁₃₀ of the polymer layer at 130°C was evaluated in the above state.

### 15. Average particle diameter

An average particle diameter (D50 particle diameter) of conductive particles (sample) was measured using Marvern's MASTERSIZER3000 device in accordance with ISO-13320 standard. Toluene was used as a solvent upon measurement. If the sample is dispersed in the solvent and irradiated with lasers, the lasers are scattered by the sample dispersed in the solvent. Since strengths and directionality of the scattered lasers vary depending on the particle size, the average particle diameter can be obtained by analyzing them using Mie theory. Through the analysis, the measurement results were converted to the particle diameters of spheres with the same volume as the dispersed sample, thereby resulting in a volume-based cumulative graph of the particle size distribution, and the particle diameter (median particle diameter) at 50% cumulative point in the graph was designated as the average particle diameter (D50 particle diameter).

### Preparation Example 1. Polydopamine-coated conductive particles

Carbon black particles (IMERYS, C-NERGY^{TM} SUPER C65) were used as the conductive particles. The average particle diameter (D50 particle diameter) of the conductive particles was about 60 nm or so. DHC (dopamine hydrochloride) (CAS No. 62-31-7) was added to a buffer solution and stirred at room temperature (about 25°C). As the buffer solution, BIOSESANG's 0.1M pH 8.5 Tris-buffer product was used. The molar concentration of DHC in the final solution was about 2 mg/mL or so. The conductive particles were dispersed (sonication for 1 hour) in the mixture of the buffer solution and DHC at a concentration of about 4 mg/mL, and stirred for additionally about 18 hours to form a coating layer of polydopamine on the conductive particles. After filtering under reduced pressure using a paper filter, the resultant particles were vacuum-dried to obtain conductive particles coated with polydopamine.

### Preparation Example 2. Synthesis of monomer (A)

The monomer of the following Formula A was synthesized in the following manner.

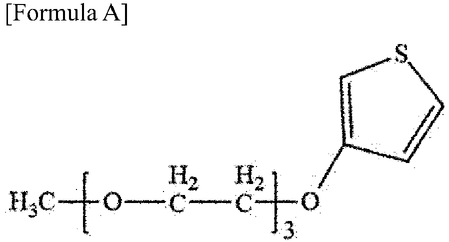

1.372 g (12.02 mmol, 1 eq) of 3-methoxythiophene and 3 g (16.83 mmol, 1.4 eq) of triethylene glycol monomethyl ether were dissolved in 100 ml of toluene together with 230 mg of p-toluenesulfonic acid (p-TsOH), and mixed. The mixture was refluxed at 120°C, and simultaneously reacted, whereby methanol produced by the reaction (transetherification) was removed by a 4A type molecular sieve filled in an extractor (soxhlet extractor). The reactant was refluxed for 24 hours, and then quenched with water, extracted with ethyl acetate, and then washed with brine, and dried over magnesium sulfate (MgSO₄). The solvent was removed by a rotary evaporator, and the residue was purified by column chromatography eluting with methylene chloride/hexane (2:1) to obtain the target compound (monomer (A)). The NMR analysis results for the target compound (monomer (A)) are as shown in Figure 4.

### Preparation Example 3. Synthesis of polythiophene (A)

To a solution in which 3.20 g (19.71 mmol, 3 eq) of iron (III) chloride was dissolved in 150mL of methylene chloride, 0.787 g (3.12 mmol, 0.475 eq) of 3-dodecylthiophene, 0.525 g (3.12 mmol, 0.475 eq) of 3-hexylthiophene, and 0.083 g (0.3285 mmol, 0.05 eq) of the monomer (A) of Preparation Example 2 were introduced, and polymerized at 25°C for 24 hours to produce polythiophene (A). The polymerization solution was placed in an osmosis membrane with an MWCO (molecular weight cut-off) of 5,000, and then immersed in 200ml of an acetonitrile solvent to remove unreacted iron (III) chloride, monomers, and low-molecular-weight oligomers. The residue precipitated inside the osmosis membrane was washed with methanol, and dried at 60°C for 12 hours to produce polythiophene (A). The weight-average molecular weight (Mw) and number-average molecular weight (Mn) of polythiophene (A) were 136,000 g/mol and 40,000 g/mol, respectively.

### Preparation Example 4. Synthesis of polythiophene (B)

To a solution in which 3.20 g (19.71 mmol, 3 eq) of iron (III) chloride was dissolved in 150ml of methylene chloride, 1 g (3.94 mmol, 0.6 eq) of 3-dodecylthiophene, 0.33 g (1.97 mmol, 0.3 eq) of 3-hexylthiophene, and 0.16 g (0.66 mmol, 0.1 eq) of the monomer (A) of Preparation Example 2 were introduced, and polymerized at 30°C for 24 hours to produce polythiophene (A). The polymerization solution was placed in an osmosis membrane with an MWCO (molecular weight of cut-off) of 5000, and then immersed in 200ml of an acetonitrile solvent to remove unreacted iron (III) chloride, monomers, and low-molecular-weight oligomers. The residue precipitated inside the osmosis membrane was washed with methanol, and dried at 60°C for 12 hours to produce polythiophene (B). The weight-average molecular weight (Mw) and number-average molecular weight (Mn) of polythiophene (B) were 118,000 g/mol and 24,500 g/mol, respectively.

### Example 1.

### Formation of polymer layer

A mixture prepared by mixing the polythiophene (A) of Preparation Example 3 and the conductive particles (P) of Preparation Example 1 in a weight ratio of 8:2 (A: P) was dispersed in toluene at a concentration of about 4 weight% to prepare a polymer solution. The dispersion was performed using an ultrasonic disperser at a temperature of about 30°C for about 4 hours. The solution was coated on a current collector with a Meyer bar, and dried in a drying oven at about 140°C for about 4 minutes or so (primary heat treatment). Thereafter, the current collector coated with the polymer solution was placed in an oven and heat-treated at 110°C for 18 hours or so (secondary heat treatment) to form a layer (polymer layer) with a thickness of about 400 nm. As the current collector, an Al foil with a thickness of about 15 µm or so was used. The oxidation potential of the polymer layer was about 3.54 V or so when measured in the "4. Measurement of polymer layer oxidation potential" manner.

### Manufacture of electrodes and electrode assembly

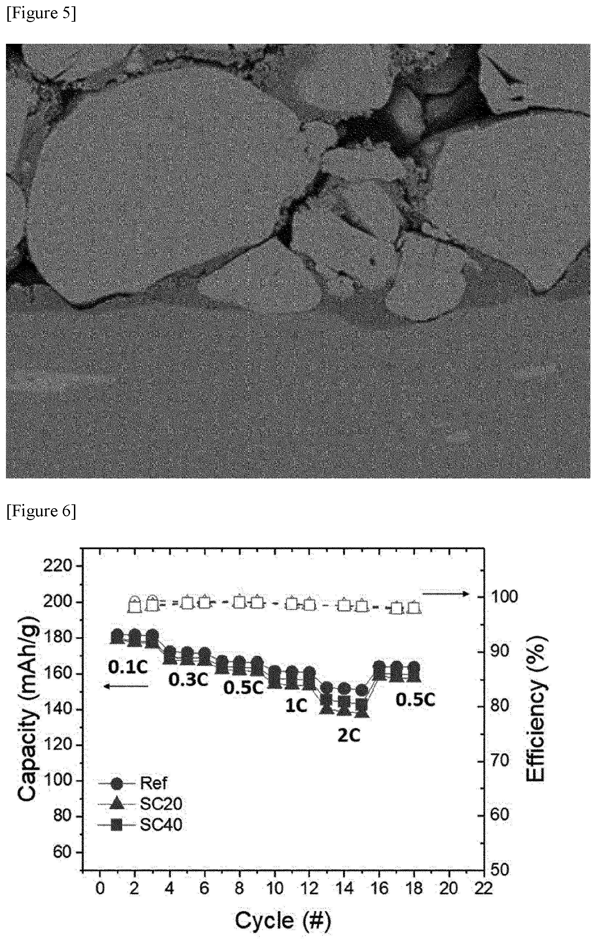

A slurry in which LiCoO₂, a conductive material (ECP (Ketjen Black) 0.5%, SFG (Trimrex graphite) 0.4%, DB (Denka Black) 0.4%), PVDF (polyvinylidene fluoride), and NMP (N-methyl-2-pyrrolidone) were mixed in a weight ratio of 77.5:1:1:20.5 (LiCoO₂: conductive material: PVDF: NMP) was applied onto the polymer layer using a doctor blade and dried at 130°C for 30 minutes to form a slurry layer (slurry loading amount: about 16 mg/cm²). The slurry layer was rolled to a porosity of about 18% or so to form an active material layer with a thickness of about 58 µm or so, thereby manufacturing an electrode. The oxidation potential of the LiCoO₂ as the electrode active material was about 3.70 V or so, when measured in the "5. Measurement of electrode active material oxidation potential" manner. The electrode was used as a positive electrode, and laminated with a separator and a negative electrode to manufacture an electrode assembly. The electrode assembly was manufactured by sequentially laminating the positive electrode, separator, and negative electrode, and the separator (SRS) and negative electrode (lithium film) used in "12. Measurement of oxidation potentials Vᵢ and V_{f}" above were used as the separator and negative electrode. Figure 5 is an SEM image of the electrode.

### Example 2.

A polymer layer was formed in the same manner as in Example 1, except that the polythiophene (B) of Preparation Example 4 was used instead of the polythiophene (A) of Preparation Example 3 upon preparing the polymer solution, and the polythiophene (B) and the conductive particles (P) of Preparation Example 1 were mixed in a weight ratio of 6:4 (B: P), and an electrode and an electrode assembly were manufactured using the same. The oxidation potential of the polymer layer was about 3.47 V or so, when measured in the "4. Measurement of polymer layer oxidation potential" manner.

### Comparative Example 1.

The polythiophene (A) of Preparation Example 3 was dispersed in toluene using an ultrasonic disperser at a temperature of about 30°C for about 4 hours to prepare a solution (concentration: about 4 weight%). The solution was coated onto a current collector using a Meyer bar, and dried in a drying oven at about 140°C for about 4 minutes or so to form a polymer layer (same thickness as in Example 1). As the current collector, an aluminum foil with a thickness of about 15 µm or so was used. The oxidation potential of the polymer layer was about 3.82 V or so, when measured using the "4. Measurement of polymer layer oxidation potential" manner. Using the laminate (current collector/polymer layer), an electrode and an electrode assembly were manufactured in the same manner as in Example 1.

Table 1 summarizes the oxidation potentials Vᵢ and V_{f} according to "12. Measurement of oxidation potentials Vᵢ and V_{f}," and summarizes the change rates ΔV₁ by calculating them using Equation 100 × (V_{f} - Vᵢ)/Vᵢ. In Table 1, the units of oxidation potentials Vᵢ and V_{f} are V, and the unit of ΔV₁ is %.

**[Table 1]**

| | Example 1 | Example 2 | Comparative Example 1 |
|---|---|---|---|
| Vi | 3.467 | 3.468 | 3.723 |
| Vf | 3.497 | 3.513 | 3.858 |
| ΔV1 | 0.87 | 1.3 | 3.63 |

From Table 1, it can be confirmed that the polymer layers of Examples have low oxidation potentials Vᵢ and small deviations between the oxidation potentials Vᵢ and V_{f}. These results mean that the electrical properties (oxidation potential, etc.) of the polymer layers re maintained stably even after repeated charging and discharging processes.

The oxidation potentials (measured in the "4. Measurement of polymer layer oxidation potential" manner) (Vₛ) of the polymer layers of Examples and Comparative Example above and the oxidation potential (measured in the "5. Measurement of electrode active material oxidation potential" manner) (Vₐ) of the electrode active material LiCoO₂ were summarized and described in Table 2 below. The ΔV₂ in Table 2 is a value obtained by substituting the oxidation potentials Vₛ and Vₐ into the equation 100 × (Vₐ - Vₛ)/Vₐ. In Table 2, the measurement results of "6. DC resistance measurement method," "7. AC impedance resistance," "8. Measurement of maximum resistance change rate (DC resistance)" and "9. Measurement of maximum resistance change rate (AC impedance)" were summarized and described.

In Table 2, Reference Example 1 is a case where an electrode manufactured in the same manner as in Example 2, except that the ratio of polythiophene (B) and conductive particles (P) is set to 5:5, is applied, and Reference Example 2 is a case where an electrode manufactured in the same manner as in Example 2 without forming a polymer layer is applied.

**[Table 2]**

| | | Example | | Comparative Example | Reference Example | |
|---|---|---|---|---|---|---|
| | | 1 | 2 | 1 | 1 | 2 |
| Vs | | 3.54 | 3.47 | 3.72 | 3.47 | - |
| Va | | 3.7 | 3.7 | 3.7 | 3.7 | 3.7 |
| ΔV2 | | 4.3 | 6.2 | -0.5 | 6.2 | - |
| DC resistance (Ω·cm) | | 80 | 65 | 370 | 57 | 4.7 |
| AC impedance (Ω) | | 10.5 | 7.7 | 42 | 6.8 | 1.7 |
| Equation 3 | ΔR1 | 198 | 184 | 210 | 170 | 2.1 |
| | on-set (°C) | 95 | 100 | 95 | 95 | - |
| Equation 4 | ΔR1 | 19.4 | 18.5 | 23.1 | 17.8 | 2.8 |
| | on-set (°C) | 95 | 100 | 95 | 95 | - |

Table 3 below summarizes the results of "10. Charge and discharge test" for Examples, Comparative Example, and Reference Examples above, and Table 4 below summarizes the results for "11. High-temperature discharge capacity reduction rate." In Table 4, the reduction rate is the result calculated using the equation 100×(C₂₅-C₁₃₀)/C₂₅. In Table 3 below, Conditions 1 to 5 are Conditions 1 to 5 described in "10. Charge and discharge test" above.

**[Table 3]**

| | Example | | Comparative Example | Reference Example | |
|---|---|---|---|---|---|
| | 1 | 2 | 1 | 1 | 2 |
| Condition 1 | 218.8 | 219.2 | 217.2 | 219.7 | 220.3 |
| Condition 2 | 218.6 | 219.1 | 216.9 | 219.4 | 220.1 |
| Condition 3 | 196.4 | 197.0 | 194.2 | 197.5 | 198.0 |
| Condition 4 | 192.4 | 193.1 | 190.4 | 193.4 | 194.0 |
| Condition 5 | 185.8 | 186.7 | 178.4 | 187.1 | 187.4 |

**[Table 4]**

| | Example | | Comparative Example | Reference Example | |
|---|---|---|---|---|---|
| | 1 | 2 | 1 | 1 | 2 |
| C25 | 218.8 | 219.2 | 217.2 | 219.7 | 220.3 |
| C130 | 22 | 38.5 | 20.5 | 45.8 | 168.5 |
| Reduction rate | 89.9 | 82.4 | 90.6 | 79.2 | 23.5 |

From Table 3, it can be confirmed that the electrodes, and the like of Examples exhibit performance equivalent to that of Reference Example 2 without applying any polymer layer, but in the case of Comparative Example 1, a potential drop during discharge due to the increased C-rate occurs. Reference Example 1, which had an increased conductive particle content, also exhibited performance like that of Examples. Through Table 4, it can be confirmed that in Examples or Reference Example 1, a high decrease in discharge capacity appears under high-temperature conditions, whereby stability can be ensured.

Table 5 summarizes the results of R_{3V}, R_{3.5V}, R₂₅, and R₁₃₀ measured in the manner described in "13. AC impedance resistance measurement at 3V and 3.5V" and "14. AC impedance resistance measurement at room temperature (25°C) and 130°C" sections above. In Table 5, Q is a value (R_{3V}/R_{3.5V}) obtained by dividing the R_{3V} by R_{3.5V}, and P is a value (R₁₃₀/R₂₅) obtained by dividing R₁₃₀ by R₂₅. In Table 4, the units of R_{3V}, R_{3.5V}, R₂₅, and R₁₃₀ are Ω.

**[Table 5]**

| | Example 1 | Example 2 | Comparative Example 1 |
|---|---|---|---|
| R3V | 39,000 | 38,000 | 40,000 |
| R3.5V | 400 | 350 | 35,000 |
| Q | 97.5 | 108.6 | 1.1 |
| R25 | 40 | 33 | 800 |
| R130 | 34,000 | 32,000 | 40,000 |
| P | 850 | 969.7 | 50 |

From Table 5, it can be known that in Examples, the impedance reduction ratios (Q) identified while the external voltage increases from 3V to 3.5V are significantly higher than in Comparative Example, which supports the excellent electrical reactivity. The low AC impedance resistance at room temperature (25°C) means that charge flow can be stably achieved through the polymer layer in the normal state. Furthermore, the high AC impedance resistance value measured at high temperatures (130°C) may mean that the PTC characteristics are expressed excellently.

### Test Example 1.

Evaluation was conducted using the electrodes of Examples and the reference electrode (electrode of Reference Example 2 in Table 2). The electrodes of Examples and the reference electrode were made to have the same thickness by adjusting the thickness of the active material layer in the reference electrode. Rate capabilities of the electrodes of Examples and the reference electrode were compared. The rate capability was identified through a galvanostatic cycling test, and in this test, the C-rate was increased from 0.1C to 2C.

Figures 6 to 10 show the results of the test. In each drawing, SC20 is the results of Example 1, SC40 or SFL is the results of Example 2, and Ref is the results for the reference electrode.

Figure 6 is the results for a coin half-cell. In Figure 6, the colored squares, circles, and triangles represent capacities, and the uncolored squares, circles, and triangles represent coulombic efficiencies.

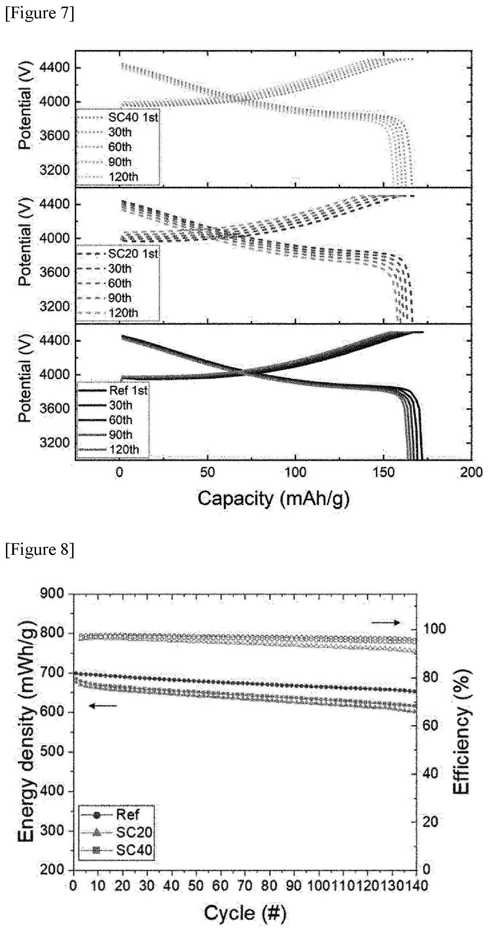

Figure 7 is charge-and-discharge profiles of the cycle test.

Figure 8 shows the results of energy density retention (140 cycles).

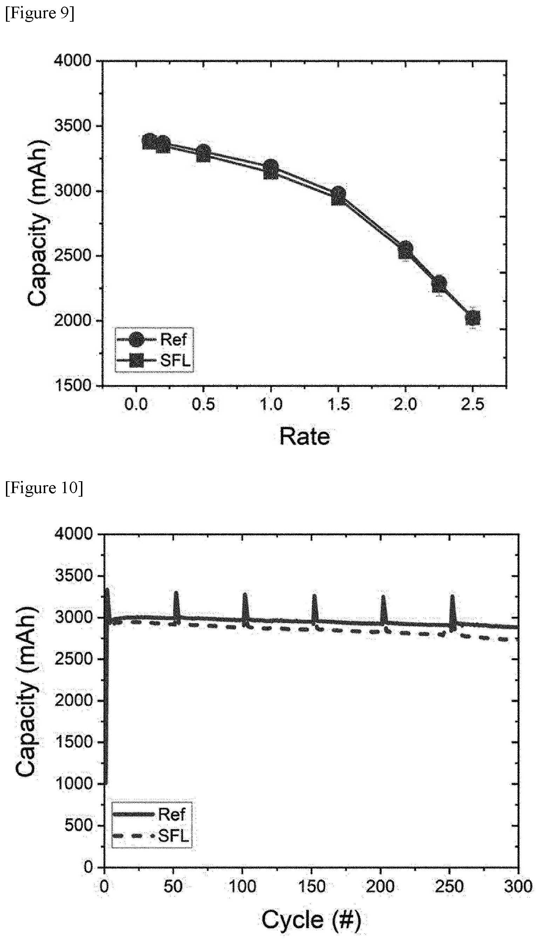

Figure 9 is the rate test results for a 3-Ah pouch cell.

Figure 10 shows the results of a cycle test for a 3-Ah pouch cell.

From the drawings, it can be confirmed that the electrode of Example 2 exhibits an initial discharge capacity of 179.5 mAhg⁻¹ and a capacity loss of less than 1.2%. In the case of the electrode of Example, the capacity gap has been maintained below 2.2% even at 2C, and it can be confirmed therefrom that there is little capacity reduction due to the polymer layer under typical battery operating conditions. In the electrodes of Examples 1 and 2, the energy density retention of the electrodes of Examples 1 and 2 was 92% and 95%, respectively, after 140 cycles, which correspond to a negligible difference from the reference electrode (Figures 7 and 8).

A 3-Ah pouch cell using the electrode of Example 2 as the positive electrode and a 3-Ah pouch cell using the reference electrode as the positive electrode were each assembled.

The positive electrodes were each manufactured using the following method.

### <Electrode of Example>

Polymer layers were each formed on both surfaces of the same current collector as used in Example 2, in the same manner as in Example 2, and positive electrode active material layers were also formed on the relevant respective polymer layers, in the same manner as in Example 2, thereby manufacturing the electrode of Example. The positive electrode active material layers were formed to have a loading density of about 24.29 mg/cm or so and a porosity of about 3.99 g/cc or so.

### <Reference electrode>

The positive electrode as the reference electrode was manufactured in the same manner as in the electrode of Example, but manufactured by forming the positive electrode active material layers on both surfaces of the current collector, respectively, without forming the polymer layer.

The negative electrode upon manufacturing the 3-Ah pouch cell was manufactured using the following method.

### <Negative electrode>

The negative electrode was manufactured by forming negative electrode active material layers on both sides of a Cu foil (copper foil) (thickness: about 8µm). The negative active material layer was formed to have a loading density of about 13.88 mg/cm or so and a porosity of about 1.75 g/cc or so. Water (I), SBR (Styrene-Butadiene rubber) (average particle diameter (D50 particle diameter): 150nm) (II), a thickener (CMC, carboxymethyl cellulose) (III), an electrode active material (1) (IV) (artificial graphite (GT), average particle diameter (D50 particle diameter): 20µm), and an electrode active material (2) (V) (natural graphite (PAS), average particle diameter (D50 particle diameter): 15 µm) were mixed in a weight ratio of 48.5:1:0.5:45:5 (I: II: III: IV: V) to prepare a slurry. The slurry was applied onto the surface of the Cu foil to a thickness of 280 µm or so by a gap coating method, dried at about 75°C for about 10 minutes, and then rolled to form the active material layer.

A stack cell was manufactured by laminating 14 negative electrodes and 13 positive electrodes. The electrode of Example or the reference electrode was used as the positive electrode. A separator was positioned between the negative and positive electrodes. As the separator, the SRS separator applied in Examples was used. A 3-Ah pouch cell was manufactured using the stack cell and an electrolyte. As the electrolyte, GTHR KOREA's electrolyte (1 M LiPF₆ solution, solvent = EC: DMC: DEC (3:3:4, volume ratio) (EC: ethylene carbonate, DMC: dimethyl carbonate, EMC: ethylmethyl carbonate)) (3 µL mAh⁻¹) was used, and as the case, an envelope-type pouch (DNP, D-EL408PH(3)) was used. The pouch cell was manufactured to have horizontal and vertical dimensions of 50 mm and 90 mm, respectively.

The capacity difference between the reference electrode and the electrode of Example was maintained at less than 1.5% when cycled from 0.1C to 2.5C. In the case of the electrode of Example, the capacity retention was 97% in the recovery cycle after 300 cycles, which was consistent with the reference electrode. From such results, it can be confirmed that the gravimetric/volumetric energy density and power density in practical batteries are maintained even with the introduction of the polymer layer.

### Test Example 2.

A nail penetration test was performed, in which a nail was inserted into a battery to measure a temperature surge. An SUS nail (diameter: about 2.5 mm, nail tip angle: 60 degrees) was inserted through the center of the 3-Ah pouch cell manufactured in Test Example 1 to determine whether the 3-Ah pouch cell was ignited. The penetration was performed by moving the nail at a speed of about 50 mm/sec. In the case of the 3-Ah pouch cell to which the reference electrode was introduced, ignition was confirmed in six or more of ten 3-Ah pouch cells applied to the test, but in the case of the 3-Ah pouch cell to which the electrode of Example was applied, ignition was confirmed in only one of ten 3-Ah pouch cells applied to the test.

### Test Example 3.

To examine how battery stability was improved under mechanical abuse conditions using the 3-Ah pouch cell manufactured in Test Example 1, an impact test was performed.

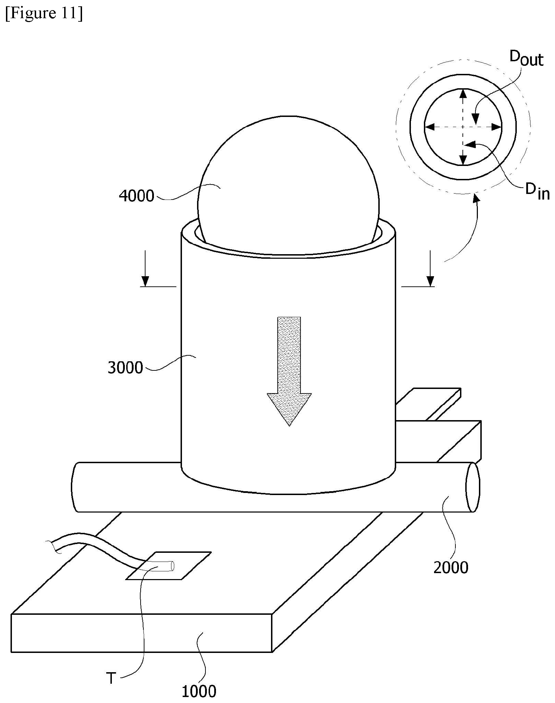

The impact test was performed in the manner shown in Figure 11.

That is, a temperature measurement device (T) (TC (temperature controller)) was attached to the surface of the 3-Ah pouch cell (1000) with an insulating tape, and a rod (2000) was positioned at the vertical center. The rod (2000) was an SUS rod with a circular cross-section of 20 mm or so in diameter and a length of 100 mm or so. A cylinder (3000) was positioned on the rod (2000). The cross-section of the cylinder (3000) is a circular shape with a diameter (Dₒᵤₜ) of 900 mm or so, and a hole with a diameter (Dᵢₙ) of 800 mm or so is formed in the center of the relevant circle. Thereafter, an impact test was performed by freely dropping an SUS spherical impact ball (4000) (weight: about 9.1 kg) with a diameter of 750 mm or so from a height of 610 mm or so toward the 3-Ah pouch cell (1000) through the hole in the center of the cylinder (3000).

The impact test was performed in an SOC (State of Charge) state of 100%.

Nineteen 3-Ah pouch cells to which the reference electrode was introduced and nineteen 3-Ah pouch cells to which the electrode of Example was introduced were each manufactured to perform the test. In the case of introducing the reference electrode, 12 of the 19 3-Ah pouch cells exploded, but in the case of introducing the electrode of Example, 17 of the 19 3-Ah pouch cells remained intact. The unexploded 3-Ah pouch cells were disassembled and the condition of each component was examined. Among the unexploded cells, with the reference electrode, the positive electrode (cathode) and the negative electrode (anode) from the cells introducing the reference electrode were significantly burnt, and the separators (SRSs) were severely deformed. Conversely, in the case of the unexploded cell among the cells introducing the electrode of Example, the respective components remained intact even after the external impact.

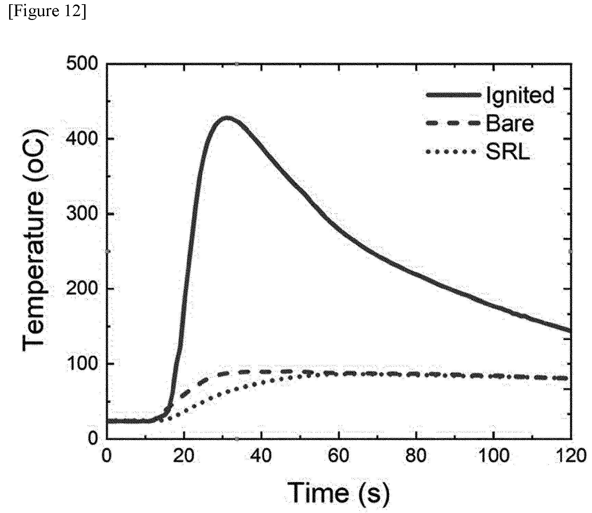

Figure 12 shows temperature changes (in situ) measured using a TC (temperature controller) (T) attached to an external surface of a pouch cell. If ignition occurred, the temperature rose rapidly (ignited), reaching up to 59°C/sec, due to cascade exothermic reactions between battery components.

Even in the absence of explosion, the pouch cell (w/o SRL) applying the reference electrode experienced localized heating, which was attributed to structural deformation from the impact-induced intense current flow. The temperature rise in the pouch cell introducing the reference electrode and unexploded occurred 1.7 times faster than in the pouch cell introducing the electrode of Example.

## Claims

1. An electrode assembly comprising:
a positive electrode; a negative electrode; and a separator between the positive electrode and the negative electrode, wherein
the separator comprises a porous polymer membrane and an inorganic particle layer,
at least one of the positive electrode and the negative electrode comprises a polymer layer,
the polymer layer comprises a conductive polymer and a conductive material, and
an absolute value of ΔV1 in Equation 1 below is 3% or less: [Equation 1] $ΔV 1 = 100 \times \left({V}_{f}-{V}_{i}\right) / {V}_{i}$
wherein, Vᵢ is an oxidation potential of the polymer layer after one cyclic voltage scan, and V_{f} is an oxidation potential of the polymer layer after ten cyclic voltage scans.

2. The electrode assembly according to claim 1, wherein the positive electrode comprises: a current collector; a polymer layer formed on the current collector; and a positive electrode active material layer formed on the polymer layer.

3. An electrode assembly comprising:
a positive electrode; a negative electrode; and a separator between the positive electrode and the negative electrode, wherein
the separator comprises a porous polymer membrane and an inorganic particle layer,
the positive electrode sequentially comprises a current collector, a polymer layer, and a positive electrode active material layer,
the polymer layer comprises a conductive polymer and a conductive material, and
an Li/Li⁺ reference oxidation potential of the polymer layer is lower than an Li/Li⁺ reference oxidation potential of the positive electrode active material.

4. The electrode assembly according to claim 3, wherein ΔV₂ in Equation 2 below is more than 0% and less than or equal to 20%: [Equation 2] ${ΔV}_{2} = 100 \times \left({V}_{a}-{V}_{s}\right) / {V}_{a}$ wherein, Vₐ is the Li/Li⁺ reference oxidation potential of the electrode active material, and Vₛ is the Li/Li⁺ reference oxidation potential of the polymer layer.

5. The electrode assembly according to claim 1 or 3, wherein a maximum temperature during an impact test is 200°C or less, and a temperature rise rate is 40°C/sec or less.

6. The electrode assembly according to claim 1 or 3, wherein the conductive material comprises a conductive core and a surface layer present on the surface of the core, and the surface layer comprises a polyphenol-based compound.

7. The electrode assembly according to claim 1 or 3, wherein the conductive polymer contains a long-chain hydrocarbon functional group.

8. The electrode assembly according to claim 1 or 3, wherein the conductive polymer contains a first hydrocarbon functional group with 10 or more carbon atoms and a second hydrocarbon functional group with 9 or less carbon atoms.

9. The electrode assembly according to claim 8, wherein a ratio of the total mole number of a monomer unit having the first hydrocarbon functional group and a monomer unit having the second hydrocarbon functional group in the conductive polymer is 80 mol% or more.

10. The electrode assembly according to claim 8, wherein a ratio M2/M1 of a mole number M2 of the second hydrocarbon functional group or a monomer unit having the functional group to a mole number M1 of the first hydrocarbon functional group or a monomer unit having the functional group is in a range of 0.01 to 100.

11. The electrode assembly according to claim 7, wherein the conductive polymer further contains a polar functional group.

12. The electrode assembly according to claim 11, wherein the polar functional group is a carboxyl group, a hydroxy group, an amino group, a cyano group, a nitro group, an ether group, or a functional group of Formula 1 below: 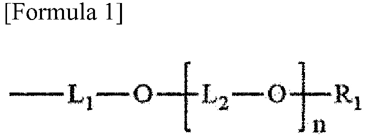 wherein, L₁ is a single bond, an alkylene group, or an alkylidene group, L₂ is an alkylene group or an alkylidene group, R₁ is hydrogen or an alkyl group, and n is a number in a range of 1 to 10.

13. The electrode assembly according to claim 11, wherein a ratio of a mole number of the long-chain hydrocarbon functional group or a monomer unit having the functional group to a mole number of the polar functional group or a monomer unit having the functional group in the conductive polymer is in a range of 1 to 500.

14. The electrode assembly according to claim 1 or 3, wherein the conductive material comprises carbon particles, carbon fibers, graphene, graphite, carbon black, carbon nanotubes, or metal particles.

15. A secondary battery comprising:
the electrode assembly according to any one of claims 1 to 14; and
an electrolyte.
